(19) Europäisches Patentamt / European Patent Office / Office européen des brevets

(11) **EP 3 913 726 B1**

(12) **EUROPEAN PATENT SPECIFICATION**

(45) Date of publication and mention
of the grant of the patent:
**26.06.2024   Bulletin 2024/26**

(21) Application number: **20742049.8**

(22) Date of filing: **15.01.2020**

(51) International Patent Classification (IPC):
*H01M 10/48* (2006.01)          *H02J 7/00* (2006.01)
*G01R 31/36* (2020.01)          *G01R 31/367* (2019.01)
*G01R 31/374* (2019.01)          *G01R 31/382* (2019.01)
*G01R 31/385* (2019.01)          *G01R 31/389* (2019.01)
*G01R 31/392* (2019.01)

(52) Cooperative Patent Classification (CPC):
**H02J 7/0048; G01R 31/367; G01R 31/374;
G01R 31/389; G01R 31/392; H01M 10/48;
H02J 7/005**

(86) International application number:
**PCT/JP2020/001003**

(87) International publication number:
**WO 2020/149288 (23.07.2020 Gazette 2020/30)**

(54) **SOH/SOC DETECTING DEVICE FOR POWER STORAGE ELEMENT, AND POWER STORAGE ELEMENT MANAGING UNIT**

SOH/SOC-DETEKTIONSVORRICHTUNG FÜR ENERGIESPEICHERELEMENT UND VERWALTUNGSEINHEIT FÜR ENERGIESPEICHERELEMENT

DISPOSITIF DE DÉTECTION SOH/SOC POUR ÉLÉMENT DE STOCKAGE D'ÉNERGIE, ET UNITÉ DE GESTION D'ÉLÉMENT DE STOCKAGE D'ÉNERGIE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.01.2019   JP 2019004769
17.06.2019   JP 2019112412
10.07.2019   JP 2019128842**

(43) Date of publication of application:
**24.11.2021   Bulletin 2021/47**

(73) Proprietor: **Goiku Battery Co., Ltd.
Osaka-shi, Osaka 532-0011 (JP)**

(72) Inventors:
• **TAKAOKA, Hiromi
Osaka-shi, Osaka 532-0011 (JP)**
• **TAKEMURA, Osamu
Osaka-shi, Osaka 532-0011 (JP)**

• **TABATA, Eiji
Osaka-shi, Osaka 532-0011 (JP)**

(74) Representative: **Horn Kleimann Waitzhofer Schmid-Dreyer
Patent- und Rechtsanwälte PartG mbB
Theresienhöhe 12
80339 München (DE)**

(56) References cited:
WO-A1-2016/151336          WO-A1-2017/047192
WO-A1-2018/001461          JP-A- 2000 270 491
JP-A- 2010 124 629          JP-A- 2014 175 066
JP-A- 2015 109 237          JP-A- 2016 038 276
JP-A- 2016 045 149          JP-A- 2017 090 426
KR-A- 20170 060 732          US-A1- 2008 103 709
US-A1- 2015 357 852          US-A1- 2016 344 068
US-A1- 2018 198 300

**Description**

TECHNICAL FIELD

The present invention relates to a SOH/SOC detecting device for a power storage element such as a secondary battery, the device being operable to detect the state of charge (SOC), which indicates the remaining energy amount of the power storage element, and the state of health (SOH) of power storage performance, which indicates the degree of deterioration or aging compared with the initial power storage performance.

The present invention further relates to a power storage element managing unit with a diagnostic function, the unit being capable of performing diagnosis and determining the state of health (SOH), which indicates the degree of deterioration of a power storage element compared with the initial state, upon charging or discharging of the power storage element.

BACKGROUND ART

Secondary batteries, which is an example of power storage element, are widely used in electronic devices, motorized equipment, vehicles, and the like. Examples of secondary batteries include lead-acid batteries, nickel-hydrogen batteries, and lithium-ion batteries. Secondary batteries can be repeatedly used with repetitive charging and discharging. Such secondary batteries can be appropriately utilized only when the user can recognize the degree of deterioration (SOH: State of Health, the current performance relative to the initial state (= 100%); also referred to as a deterioration rate) of the secondary battery, as well as the remaining power (SOC: State of Charge, also referred to as a charging depth, in which 0% indicates "EMPTY" and 100% indicates "FULL") of the secondary battery.

Various techniques for estimating the SOH and the SOC of a secondary battery have been previously proposed (see, for example, Patent Documents 1 to 3).

In addition, although secondary batteries are widely used in various fields, there is no means for accurately detecting the remaining power of a secondary battery; therefore, the users of devices having secondary batteries as power sources are actually suffering from a trouble of sudden malfunction of the device caused by depletion of electrical energy, as well as anxiety over such a trouble.

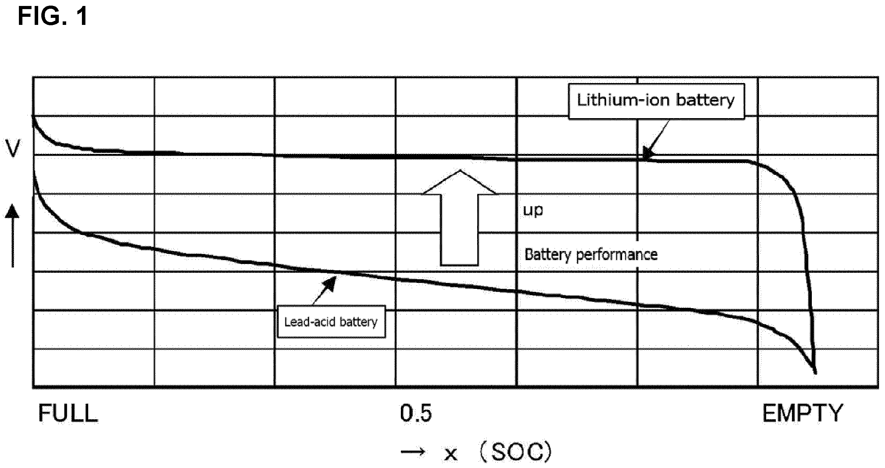

This trouble is derived from the problem such that, when a method of measuring the terminal voltage of the secondary battery and estimating the remaining power in association with the measured terminal voltage is performed, as shown in Fig. 1, the terminal voltage V with respect to the remaining power hardly changes except for the extreme cases such as "EMPTY" or "FULL", and such a phenomenon becomes more significant in high-performance secondary batteries, such as lithium-ion batteries. Therefore, it is difficult to determine the remaining power by referring to the terminal voltage. The necessary detection accuracy thus problematically exceeds a practical range.

In addition, as another method of detecting the remaining power of a secondary battery, a method of estimating the remaining power by performing time integration of entering and exiting currents and adding or subtracting the increased or decreased amount of electricity from the battery to/from a reference value has been used. This case, however, poses a problem in reference value setting, for example, determination as to whether the reference value is set to a fully-charged value or a non-charged value (0), and also has a defect that the loss inside the battery at the time of charging and discharging is not reflected in the power storage amount, thus resulting in rather lenient estimation in the detection of the remaining power.

A technique for accurately detecting the remaining power of a secondary battery is indispensable not only for electric vehicles which will be further widespread in the future but also for devices driven by electrical energy stored in a battery, and establishment of such a technique is in urgent need.

A secondary battery has two electrodes, i.e., a negative electrode and a positive electrode, and materials constituting these electrodes are selected so that the chemical potential of the negative electrode is higher than that of the positive electrode. Further, when the working medium deposited on the negative electrode, such as lithium ions in a lithium-ion battery, slide down to the positive electrode, energy proportional to the difference in chemical potential and the number of lithium ions is released to an external electric circuit to produce energy. This is the discharge process of a secondary battery.

Further, in the process of charging a secondary battery, the potential of the positive electrode is increased to a higher level than that of the negative electrode so that the working medium deposited on the positive electrode is fallen to the negative electrode. This process requires an external power source for increasing the potential.

As understood from above, the operation inside the secondary battery may simply be regarded as transfer of the working medium between the positive electrode and the negative electrode; however, since an electrochemical reaction of oxidation/reduction occurs in the electrode or at the electrode interface, for example, quantification of the reaction amount per unit of time, control of the amount change, and the like require an extremely complicated and substantial device configuration.

However, regarding the use of electric energy from a secondary battery, since a device circuit or an electronic device simply depends on the flow of electrons, if an electrochemical reaction can be detected efficiently and promptly, it is presumably possible to appropriately recognize the battery state and establish a managing method thereof. Therefore, such a detection of a battery state based on an electrochemical reaction in a secondary battery has been desired.

Specifically, in a system in which electric energy is extracted from a charged secondary battery, and the extracted energy is converted into power to perform an intended operation, such as an electric vehicle including electric automobiles and hybrid cars, its required basic performance is that the remaining power (state of charge) can be accurately measured and confirmed in a short time during the operation. However, in many cases of the existing technologies, the user can recognize the state of charge only unclearly, and is therefore often involved in unexpected trouble or a failure in operating an electric vehicle in an expected manner.

The batteries used in these electric devices, electric vehicles, and the like are so-called secondary batteries such as lead-acid batteries, nickel-hydrogen batteries, and lithium-ion batteries, which can be repeatedly used by repetitive discharging and charging. For example, charging and discharging of a lithium-ion battery are performed in such a manner that lithium ions in the secondary battery move between a positive electrode and a negative electrode through a nonaqueous electrolyte, and the lithium ions are inserted into or desorbed from an active material of the positive electrode or the negative electrode.

The performance of these secondary batteries deteriorates as charging/discharging is repeated many times or due to overcharging or overdischarging, because the initial storage capacity cannot be maintained due to deterioration of an electrolyte, which is an internal structure present in an electrolytic solution of the secondary battery, damage or condition change of an electrode plate, and the like. This ultimately causes fatal damage of the secondary battery.

In view of the above, there has been a demand for a technique of accurately and instantaneously detecting the SOH and the SOC of a power storage element such as a secondary battery.

In recent years, devices using electrical energy temporarily stored in a battery mounted on a photovoltaic power generation panel (also referred to as a solar cell panel or PV), an electrically driven vehicle (EV), a power storage device, or the like, or portable devices using electrical energy temporarily stored in a small battery mounted on various information terminals or the like have been rapidly widespread.

However, the output voltage is merely 1.2V for nickel metal hydride batteries, 2V for lead-acid batteries, and less than 4V for lithium-ion batteries, which are excessively low as a single cell. For this reason, there are many devices in which a plurality of cells are connected in series to form a battery pack to produce a high voltage of at least 12V or as high as 360V, thereby increasing the power.

During charging and discharging of such a battery pack, the current flow is equal both upon charging and discharging in any cell, whereas the voltage of each cell according to the current is usually different. Therefore, observation of the battery voltage of the entire battery pack is not enough, because the voltage of each cell varies, and it is possible that a given cell has a value more than an allowable value for a battery cell. A cell with an excessive value may cause a battery system trouble (so-called a hazard) such as swelling, heat generation, smoke generation, explosion, and the like. Further, when a battery is connected to a load, an abnormal decrease in the voltage of a given cell is often covered by the voltage of another cell and power is forcibly supplied to the load. In this case, the cell may have an over-discharge state and result in electrode destruction. Upon next charging, this cell induces over-charging prior to other cells, thus causing a hazard in various battery systems.

In order to prevent such hazards in various battery systems, it is indispensable to always monitor the voltage of each cell (unit cell), which is a constituent element of the battery system, detect individual voltage data, and perform an appropriate control based on the data, thereby ensuring the long life and safety of the battery system. Therefore, a battery management system (BMS) has hitherto been used as a device for monitoring the voltage of each cell (unit cell) of a battery system and performing predetermined control on the battery system. The battery management system includes a battery management unit (BMU) as a unit for measuring voltages and temperatures of individual cells included in the battery system and performing monitoring and control (protection) of the battery system.

In order to perform diagnosis using a diagnostic device for performing, for example, diagnosis of deterioration of a power storage element, the power storage element is removed from a device incorporating the power storage element and is attached to the diagnostic device. In contrast, if the diagnosis is performed using a battery management system (BMS), the diagnosis of a power storage element must be performed in a state in which the power storage element is attached to the power storage element module. Therefore, it is necessary to perform the diagnosis using a BMS even during charging and discharging, unlike the case of performing diagnosis with a diagnostic device.

More specifically, while diagnostic devices perform diagnosis with respect to a power storage element in an unused state (non-charging/discharging state), BMSs are used to diagnose a power storage element being used (being charged or discharged).

In addition, power storage elements are used in many different ways. For example, they are detachable from a device that supplies electric power in some cases; in other cases, they are attached as a part of a device (for example, a power storage element module) in an undetachable state (in which the power storage element cannot be detached from the device). Since a diagnostic device that performs diagnosis by being connected to an arbitrary power storage element can be installed in any place and environment during the diagnosis, and therefore is less likely to be affected by the environment (for example, temperature environment) in use. However, when diagnosis is performed using a BMU for managing a power storage element attached to a device, the environment in use changes depending on the installation location of the device, and the diagnosis is likely to be affected by the environment in use. As a result, the measurement result of SOH may be affected by a temperature change or the like. Therefore, when diagnosis is performed using a BMU, a technique of allowing diagnosis of a power storage element under variable temperatures in use, more specifically, a technique of allowing diagnosis in environments having a wide range of temperature will be necessary.

Under such circumstances, there has been a demand for a power storage element managing unit capable of accurately detecting the SOH of a power storage element in a wide range of temperature environments.

PRIOR ART DOCUMENTS

PATENT DOCUMENTS

Patent Document 1: Japanese Patent No. 3752249
Patent Document 2: U.S. Patent No. 7075269
Patent Document 3: Chinese Patent No. 100395939

US 2016/344068 A1 discloses a battery pack comprising a lithium air battery configured to receive air and discharge a discharge gas, the lithium air battery comprising a cell module configured to generate electricity based on oxidation of a lithium metal and reduction of oxygen; and a battery management unit configured to control charging and discharging of the lithium air battery, wherein the battery management unit comprises a measurement unit configured to measure a composition ratio of the discharge gas, measure a current, and to generate discharge gas data and current data; a capacity estimation unit configured to estimate a present capacity of the lithium air battery based on the discharge gas data and the current data and to generate a present capacity data; and a state of health estimation unit configured to estimate a state of health of the lithium air battery based on the present capacity data.

US 2008/103709 A1 discloses a battery management system including a sensing unit and a micro control unit. The sensing unit measures a battery temperature and a battery current. The MCU receives the battery temperature and current, detects battery internal resistance corresponding to an estimated state of charge (SOC) and the battery temperature when the estimated SOC is included within an SOC area corresponding to the transmitted battery temperature, and estimates a battery state of health (SOH) by using the battery internal resistance. In the SOC area, a variation of the battery internal resistance is minimized.

US 2015/357852 A1 discloses a battery control device that can accurately detect a state of charge even if characteristics relating to the state of charge change as a result of battery degradation. This battery control device is provided with map data describing the correspondence relationship between an open-circuit voltage and a state of charge of the battery and outputs different state-of-charge values for the same open-circuit voltage according to the amount of elapsed time.

NON-PATENT DOCUMENTS

Non-patent Document 1: "Denki Kagaku Gairon" (Electrochemistry), Yoshiharu Matsuda, et al. (Maruzen Publishing Co.,Ltd.)
Non-patent Document 2: "Hyomengijyutusha no tameno Denki Kagaku" (Electrochemistry for Surface Engineer), Shiro Haruyama (Maruzen Publishing Co.,Ltd.)

SUMMARY OF INVENTION

Technical Problem

An object of the present invention is to provide a SOH/SOC detecting device for a power storage element, the device being capable of accurately and instantaneously detecting the state of health SOH and the state of charge SOC of a power storage element, such as a secondary battery, thereby enabling recognition of a battery state.

Another object of the present invention is to provide a power storage element managing unit capable of accurately detecting the state of health SOH of a power storage element according to a wide range of temperature environments.

Solution to Problem

The problem to be solved by the present invention is as described above, and means for solving the problem is described below.

Specifically, according to one aspect, a SOH/SOC detecting device for a power storage element according to the present invention is a SOH/SOC detecting device for detecting the state of health SOH and the state of charge SOC of a power storage element having the features of claim 1, namely:

a control unit having a calculating means for executing a predetermined calculation; and
a measuring means for measuring a voltage and a current of the power storage element,
the control unit determining overvoltage δ during the operation of the power storage element by calculation based on measured values of rising voltage and current at a start of charging of the power storage element according to the battery equation shown in [Math. 1] below.

[Math. 1]

$$\Delta v = v - \eta_{eq}^*$$

$$\Delta v_1 = \delta + \frac{2}{f} \tanh\left(\frac{1}{2} f \delta\right)$$

wherein $\Delta v$ represents a differential voltage between a terminal voltage v of the power storage element and an electro motive force $\eta eq^*$, $\Delta v_1$ represents a potential difference generated by an oxidation-reduction reaction on an electrode surface during operation, and the constant f represents a physical constant based on the Faraday constant, the Boltzmann constant, and the absolute temperature.

More specifically, in the SOH/SOC detecting device for a power storage element according to the present invention, the control unit measures the rising voltage at the start of charging of the power storage element, performs individual calculations of "overvoltage δ" and "potential difference due to internal resistance" based on the difference of the rising voltage from a balanced voltage according to the "battery equation" shown in [Math. 1], and detects "dynamic internal resistance" due to the electrode reaction from a current value simultaneously measured.

The details of the "battery equation" are described later.

In the SOH/SOC detecting device for a power storage element according to the present invention, the control unit determines the overvoltage δ during operation according to the condition of [Math. 1] where the two equations are equal.

In the SOH/SOC detecting device for a power storage element according to the present invention, the control unit measures a time course of a fall voltage when charging of the power storage element is blocked to calculate electrolyte characteristics of the power storage element.

As a result, the movement of the working medium (for example, lithium ions) in the electrolyte charged between the electrodes can be accurately and precisely determined. This further determines the quality of the characteristics of the electrolyte, which is a battery constituent member that affects the battery characteristics.

The electrolyte characteristics refer to numerical values of a diffusion resistance, an electrophoretic resistance, and a capacitor component formed by repulsion between ions, which are regarded as electric characteristic values of the electrolyte. By determining these numerical values, an electrical equivalent circuit can be established, and the SOC and the SOH can be accurately identified by correcting them in view of the electrolyte characteristics even during charging or discharging.

In the SOH/SOC detecting device for a power storage element according to the present invention, the control unit determines the dynamic internal resistance Dir during charging according to the measured value of the voltage and the battery equation of [Math. 1], and calculates the state of health SOH from the Dir.

More specifically, in the SOH/SOC detecting device for a power storage element according to the present invention, the control unit determines the dynamic internal resistance Dir during charging according to the measured value of the voltage and the battery equation shown in [Math. 1], and calculates the capacity of the battery from the minimum Dir obtained by determining the minimum value of Dir by referring to the state of charge SOC.

In the SOH/SOC detecting device for a power storage element according to the present invention, the control unit obtains a battery capacity by determining a battery-specific coefficient according to [Math. 2], which is a voltage-current characteristic expression with respect to the overvoltage δ, according to the measured value of the voltage and the battery equation of [Math. 1].

[Math. 2]

$$I = 2K_0 S_c \ \sinh(\frac{1}{2}f\delta)$$

According to another aspect, a SOH/SOC detecting device for a power storage element according to the present invention is a SOH/SOC detecting device for detecting the state of health SOH and the state of charge SOC of a power storage element having the features of claim 6, namely:

a measuring means for measuring a voltage and a current of the power storage element; and
a control unit having a calculating means for executing a predetermined calculation,
the control unit determining overvoltage δ during the operation of the secondary battery by calculation based on a predetermined condition regarding charging or discharging of the power storage element according to the battery equation shown in [Math. 1].

[Math. 1]

$$\Delta v = v - \eta_{eq}^*$$

$$\Delta v_1 = \delta + \frac{2}{f}\tanh\left(\frac{1}{2}f\delta\right)$$

wherein $\Delta v$ represents a differential voltage between a terminal voltage v of the power storage element and an electro motive force neq*, $\Delta v_1$ represents a potential difference generated by an oxidation-reduction reaction on an electrode surface during operation, and the constant f represents a physical constant based on the Faraday constant, the Boltzmann constant, and the absolute temperature.

In the SOH/SOC detecting device for a power storage element according to the present invention, the predetermined condition is a time course of a fall voltage at a start of discharging.

In the SOH/SOC detecting device for a power storage element according to the present invention, the predetermined condition is a measured value of a rising voltage when discharging is blocked.

In the SOH/SOC detecting device for a power storage element according to the present invention, the predetermined condition is a measured value of a rising voltage when a charging current is increased or when a discharging current is decreased.

In the SOH/SOC detecting device for a power storage element according to the present invention, the predetermined condition is a time course of a fall voltage when a charging current is decreased or when a discharging current is increased.

In the SOH/SOC detecting device for a power storage element according to the present invention, the predetermined condition is a time course of a fall voltage in transition from charging to discharging.

In the SOH/SOC detecting device for a power storage element according to the present invention, the predetermined condition is a measured value of a rising voltage in transition from discharging to charging.

Further, a power storage element managing unit of the present invention has the features of claim 13.

The power storage element managing unit of the present invention further comprises:

a temperature measuring means for measuring a temperature of the power storage element,
wherein the control unit comprises an acquisition unit that acquires the temperature of the power storage element by the temperature measuring means, and, based on a relationship between the temperature of the power storage element and the dynamic internal resistance Dir of the power storage element in a brand-new state stored in advance, acquires a dynamic internal resistance Dir of the power storage element in a brand-new state corresponding to the temperature of the power storage element, and the SOH calculation unit calculates the state of health SOH of the power storage element based on the dynamic internal resistance Dir of the power storage element in a brand-new state acquired by the acquisition unit.

The power storage element managing unit of the present invention is attached to an apparatus in which another power storage element is incorporated, and measures the state of health SOH of another power storage element.

ADVANTAGEOUS EFFECTS OF INVENTION

The SOH/SOC detecting device for a power storage element of the present invention is capable of accurately and instantaneously detecting the state of health SOH and the state of charge SOC of a power storage element, such as a secondary battery.
The power storage element managing unit of the present invention makes it possible to provide a power storage element managing unit capable of accurately detecting the state of health SOH of a power storage element according to a wide range of temperature environments.

BRIEF DESCRIPTION OF DRAWINGS

Fig. 1 is a diagram showing changes in electro motive force with respect to the SOC for different battery types.
Fig. 2 is a block diagram showing a fundamental structure of a SOH/SOC detecting device for a secondary battery according to one embodiment of the present invention.
Fig. 3 is a characteristic diagram for obtaining a solution of a battery equation showing a battery operation during charging.
Fig. 4 is a diagram showing an electric circuit equivalent circuit inside a battery during charging.
Fig. 5 is a characteristic diagram from a long-term stationary state to a state immediately after current application.
Fig. 6 is a chart in which a battery equation and current-voltage characteristics are combined.
Fig. 7 is a diagram showing time characteristics of rise and fall of voltage-current.
Fig. 8 is a block diagram schematically showing a structure of a charging device including a battery management system having a battery management unit according to one embodiment of the present invention.
Fig. 9 is a block diagram showing a structure of a microcomputer.
Fig. 10 is a graph showing variations in charging/discharging current and terminal voltage.
Fig. 11 is a graph showing a relationship between dynamic internal resistance Dir and voltage.
Fig. 12 is a graph showing Dir-temperature characteristics.
Fig. 13 is a diagram showing an example of a discharging-based diagnostic circuit.
Fig. 14 is a diagram showing an example of a charging-based diagnostic circuit.

DESCRIPTION OF EMBODIMENTS

The measurement principle for measuring the state of health SOH and the state of charge SOC of a power storage element, such as a secondary battery, according to the present invention is described below with reference to the drawings. Hereinbelow, the present invention is specifically explained by describing a secondary battery as an example of power storage element. Hereinafter, a secondary battery may be simply referred to as a battery.

[Measurement Principle]

One of the methods for accurately detecting the state of charge of a secondary battery is a method of accurately quantifying the relationship between an increase or decrease in electro motive force (EMF) and an increase or decrease in state of charge in advance, and then measuring the EMF and determining the value of the state of charge. However, although the current state of charge can be detected from a balance of charge by reducing the used power from the original state of charge while measuring as long as the original state of charge is accurately determined, if the original state of charge is not accurately measurable, the resulting calculation of state of charge is unreliable. In particular, supply of electricity during charging and extraction of electricity during discharging involve heat loss due to electrical resistance (internal resistance) inside the battery, thus causing an error of the balance; therefore, accurate measurement of the state of charge is nearly impossible.
Another method for accurately measuring the state of charge of a secondary battery is measurement of the electro motive force of a battery. However, the voltage during operation does not indicate the electro motive force, and the measured value fluctuates very slowly when the operation is stopped. For example, when the charging is blocked, the voltage value gradually decreases and settles at a constant value over a long period of time. Further, when the discharging is blocked, the voltage gradually increases and converges to a constant value also over a long period of time.

The voltage thus converged is the electro motive force of a battery, which is an indicator of the state of charge (SOC) of the battery. More specifically, the measurement of electro motive force takes an extremely long time, and the measurement is impossible once the battery is charged or discharged unless the battery is left unattended for a long time. Therefore, it is not possible to measure the state of charge of a battery, i.e., a usable amount of electricity (power) every moment, thus making it difficult to control equipment having a battery and causing troubles in using batteries.

Fig. 1 is a diagram illustrating a change in battery voltage with respect to the state of charge of a secondary battery. More specifically, Fig. 1 shows the relationship between the state of charge x (SOC) and the electro motive force V for different types of battery (lithium-ion battery, lead-acid battery). The voltage thus converged in Fig. 1 is the electro motive force of a battery, which is an indicator of the state of charge (SOC) of the battery.

As shown in Fig. 1, although the variation range of the electro motive force V with respect to the state of charge x (SOC) is large in a lead-acid battery, the variation is insignificant in a lithium-ion battery; therefore, it is difficult to identify the state of charge x (SOC) from the electro motive force V of a lithium-ion battery.

The measurement principle according to the SOH/SOC detecting device for a secondary battery of the present invention and the power storage element managing unit of the present invention applies a "battery equation" obtained as a result of a battery reaction theory, for the purpose of instantaneously and accurately measuring the state of charge or the like of a secondary battery.

The "battery equation" is specifically an equation originated from a battery reaction theory related to the secondary battery, and is a circuit equation based on overvoltage and reaction resistance associated with oxidation-reduction reactions.

The SOH/SOC detecting device for a secondary battery of the present invention and the power storage element managing unit of the present invention instantaneously measure a dynamic internal resistance Dir from a battery equation when specifying the battery capacity of the secondary battery, and calculate the state of charge (SOC) or the state of deterioration (also referred to as SOH or state of health), which is the current capacity of the secondary battery, using a constant unique to the battery type.

The device for detecting the state of health and the state of charge of a secondary battery of the present invention and the power storage element managing unit of the present invention also perform another method of instantaneously measuring a current characteristic coefficient by using both a battery equation and a voltage-current equation, and instantaneously measuring a capacity proportional to the coefficient to calculate the state of charge (SOC) or the state of health (SOH), which is the current capacity of the battery.

The outline of the logic related to the battery reaction is described below, as additional explanation of the "battery equation" established by the present inventors.

Although the following description is based on the configuration of a lithium-ion battery for the sake of convenience, the description is not to particularly limit the type of battery.

First, overvoltage and current are discussed, assuming that the battery reaction at the negative electrode is a reaction rate-limiting step. The limitation of reaction speed is described below for reference. A battery is mainly made of a positive electrode, a negative electrode, and an electrolyte that controls ion transfer between the electrodes. The amount of electrons or the amount of ions passing through these electrodes per unit of time is regarded as equal based on the logic of continuity. Therefore, the amount of electrons/ions flowing through the constituent that is most difficult for them to pass through regulates the entire flow, and therefore is referred to as the limitation of reaction speed.

The oxidation-reduction reaction is expressed by the following formula based on the Arrhenius theory, and the current density is determined by the following equation, provided that the abbreviations are defined as follows.

[Math. 1]

$$-i = nF\left\{\kappa_{red}^0 c_o(0,t)e^{-(1-\alpha_c)nf\eta} - \kappa_{ox}^0 c_r(0,t)e^{\alpha_c nf\eta}\right\}$$

wherein i represents the current density in the negative electrode, n represents the number of charged electrons (1 for lithium ion), F represents the Faraday constant (96000[c ·mol⁻¹], $k_{red}^0$ and $k_{ox}^0$ represent reduction/oxidation speed constants, $c_0(0,t)$ and $c_r(or,t)$ represent oxidant/reductant concentrations on a reaction interface, $\alpha_c$ represents mobility (generally 1/2), f = F/RT (R represents the atmosphere constant, T represents the absolute temperature), and $\eta$ represents overvoltage.

Since the current is 0 in the equilibrium state, the balanced voltage $\eta$eq can be easily calculated from [Math. 1].

[Math. 2]

$$\eta_{eq} = \frac{1}{nf}\left\{\ln\left(\frac{\kappa_{red}^0}{\kappa_{ox}^0}\right) + \ln\left(\frac{c_o(0,t)}{c_r(0,t)}\right)\right\} = E_c^{O\prime} + \frac{1}{nf} ln\left\{\frac{c_o(0,t)}{c_r(0,t)}\right\}$$

More specifically, the balanced voltage $\eta$eq has a different value depending on the concentration ratio $c_O(0,t)/c_r(0,t)$.

The concentration at the reaction interface has a constant value when the time t has passed infinitely. This is expressed by the following formula.

[Math. 3]

$$c_r(0,\infty) \to c_r^* \qquad\qquad c_o(0,\infty) \to c_o^*$$

Therefore, by substituting them into [Math. 2], the following Nernst equation is obtained.

[Math. 4]

$$\eta_{eq}^* = E_c^{O\prime} + \frac{1}{nf} ln\left\{\frac{c_o^*}{c_r^*}\right\}$$

Ec$^{O'}$ is expressed as follows.

[Math. 5]

$$E_c^{O\prime} = \frac{1}{nf}\ln\left(\frac{\kappa_{red}^0}{\kappa_{ox}^0}\right)$$

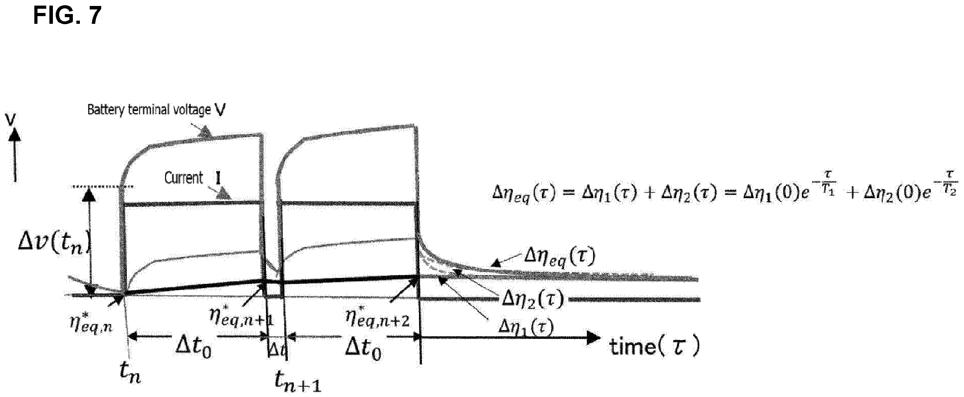

The balanced voltage in a transient state is expressed on the basis of a voltage in an equilibrium state when a sufficient time is taken. It is considered that the charging current flows until time $t_{O-}$, and therefore the concentration of the oxidant at the interface is maintained immediately after the current is cut off at time $t_{O+}$ (see Fig. 7).

The balanced voltage at this time is expressed by [Math. 3], and the balanced overvoltage after being left for a long period of time is expressed by [Math. 4]. By taking the difference, the following equation is obtained.

[Math. 6]

$$\Delta\eta_{eq}(t) = \eta_{eq} - \eta_{eq}^* \approx \frac{1}{nf} ln\left\{\frac{c_o(0,t)}{c_o^*}\right\}$$

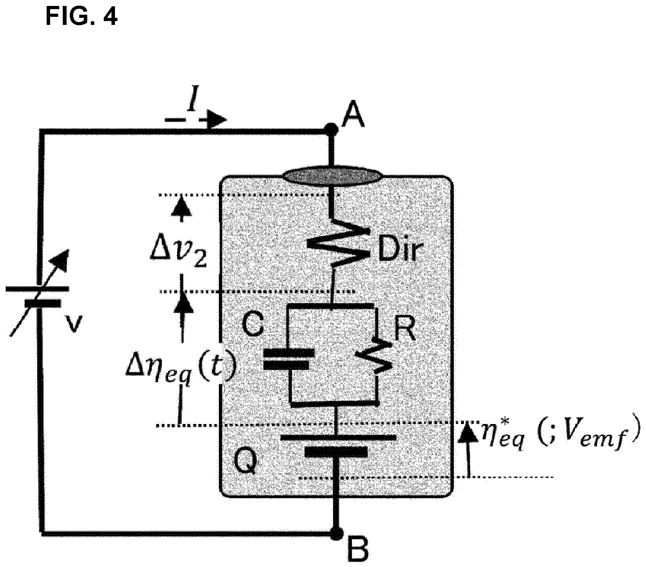

$\Delta\eta$eq (t) is a potential that is present when a tank circuit of a capacitor and a resistor is formed as an electrical equivalent circuit by diffusion of lithium ions in an electrolyte in a dissolved form far from the electrode, and diffusion of lithium ions in an oxidation-reduction field or electrophoresis thereof in an electric field in the immediate vicinity of the electrode (see Fig. 4). The following method shows a way to identify the electroconductivity of lithium ions in the electrolyte and a capacitor component as an electrical double layer by cutting off the charging at a certain time point during the steady charging and then measuring a change in voltage every moment thereafter.

An electrical double layer refers to a layer in which positive charges and negative charges are arranged to face each other with a very short distance at the interface between an electrode and an electrolyte solution.

[Formation Process of Δηeq (t)]

At the rise of the charging current I after the long-term stationary state, for example, the reduction reaction at the negative electrode corresponds to the concentration $c_O(0,t)$ of the oxidant present on the reaction surface at t = 0, and this value is equal to $c_O^*$ considering the long-term stationary state. By the negative electrode reaction, this concentration is consumed and reduced, and is stored as $c_r^*$.

In order to compensate the consumption, it is necessary to supply oxidants from the offshore, and Δηeq (t) is equal to the value obtained by multiplying the natural logarithm of the ratio of the initial $c_O^*$ to the $c_O(0,t)$ during the compensation by a physical constant.

At this Δηeq (t), the ions that have reached the combative reaction surface are repelled by the predecessor ions, and an ion counter zone is formed to be so-called an electrical double layer. At the same time, the diffusion forms a stable tank circuit. This formation process is expressed by the following equation.

[Math. 7]

$$\Delta \eta_{eq}(\tau) = IR \cdot \left\{ 1 - e^{-\frac{\tau}{T}} \right\}$$

When the charging was performed for a certain time ($\tau = t_c$) and is blocked thereafter, the potential difference of the tank circuit immediately after the blocking is expressed by the following equation.

[Math. 8]

$$\Delta \eta_{eq}(\tau_c) = IR \cdot \left\{ 1 - e^{-\frac{\tau_c}{T}} \right\} = \Delta \eta_{eq}(t = 0)$$

The voltage v(t) after the blocking is expressed by the following general formula.

[Math. 9]

$$v(t) = \Delta \eta_{eq}(0) \cdot e^{-\frac{t}{T}} + \eta_{eq,1}^*$$

This equation includes Δηeq (0), T, and neq*, 1 as unknown numbers, which are determined from the following three simultaneous equations.

[Math. 10]

$$v(0) = \Delta \eta_{eq}(0) + \eta_{eq,1}^*$$

$$v(t_1) = \Delta \eta_{eq}(0) \cdot e^{-\frac{t_1}{T}} + \eta_{eq,1}^*$$

$$v(t_2) = \Delta \eta_{eq}(0) \cdot e^{-\frac{t_2}{T}} + \eta_{eq,1}^*$$

Then, assuming $t_2 = 2t_1$, three point voltage measurement is performed at equal time intervals. Then, further assuming $e^{-t\,1/T} = x$, the above three equations become the following algebraic equations.

[Math. 11]

$$v(0) = \Delta\eta_{eq}(0) + \eta^*_{eq,1} \qquad (a)$$
$$v(t_1) = \Delta\eta_{eq}(0) \cdot x + \eta^*_{eq,1} \qquad (b)$$
$$v(2t_1) = \Delta\eta_{eq}(0) \cdot x^2 + \eta^*_{eq,1} \qquad (c)$$

The solution of the equations is obtained as follows.

[Math. 12]

$$x = e^{-\frac{t_1}{T}} = \frac{v(t_1) - v(2t_1)}{v(0) - v(t_1)} \qquad \rightarrow \qquad T = \frac{t_1}{ln\left\{\frac{v(0) - v(t_1)}{v(t_1) - v(2t_1)}\right\}}$$

$$\Delta\eta_{eq}(0) = \frac{\{v(0) - v(t_1)\}^2}{v(0) - 2v(t_1) + v(2t_1)}$$

from equation (a) $\qquad \eta^*_{eq,1} = v(0) - \Delta\eta_{eq}(0) = \frac{v(2t_1)v(0) - v(t_1)^2}{v(0) - 2v(t_1) + v(2t_1)}$

Using this relationship, measurement of voltages v(0), v(t_1), and v(2t_1) after the blocking determines the tank circuit voltage Δηeq(0) corresponding to the charging current, the electro motive force neq*,1 corresponding to the time of complete discharge of the tank circuit, and the tank circuit time constant T, thereby enabling quantitative determination of the electrolyte characteristics.

As shown in Fig. 7, Δηeq(0) exists at the time the charging is blocked. Thereafter, the charge amount in the tank circuit disappears with time by the parallel resistance, and Δηeq(∞) becomes 0 after passage of a certain time.

[Charge Transfer Process by Electrode Reaction]

The following discusses overvoltage and current, assuming that the battery reaction at the negative electrode is a reaction rate-limiting step.

The current flows only after an overvoltage δ greater than the balanced voltage (Δηeq + neq*) is added. By introducing the equation η = δ + Δηeq + neq* in [Math. 1] and changing the form, the following equation is obtained.

[Math. 13]

$$-i = \sqrt{\kappa^0_{red}\kappa^0_{ox}}\sqrt{c_o(0,t)c_R(0,t)} \cdot e^{\frac{1}{2}f\delta}\{e^{-f\delta} - 1\}$$

Then, a calculation was performed using the relational expressions [Math. 1], [Math. 2], [Math. 3], and [Math. 4], while assuming that the mobility $\alpha_c$ = 1/2, and the number of charged electrons n = 1.

[Math. 13] is a relational expression to determine a current density established with respect to the displacement δ from an arbitrary balanced voltage. Since the current I is obtained by multiplying this expression by the effective electrode surface area S, the current-potential relational expression is as follows.

[Math. 14]

$$I = K_x S_c \ (e^{\frac{1}{2}f\delta} - e^{\frac{-1}{2}f\delta}) = 2K_x S_c \ \sinh(\frac{1}{2}f\delta)$$

Kx in [Math. 14] can be expressed as follows.

[Math. 15]

$$K_x = FS_c \sqrt{\kappa^0_{red}\kappa^0_{ox}}\sqrt{c_o(0,t)c_r(0,t)}$$

δ is an overvoltage value greater than the virtual balance (balanced voltage; neq* + Δηeq), provided that the current value is determined by δ (greater than the balanced voltage neq*) + Δηeq.

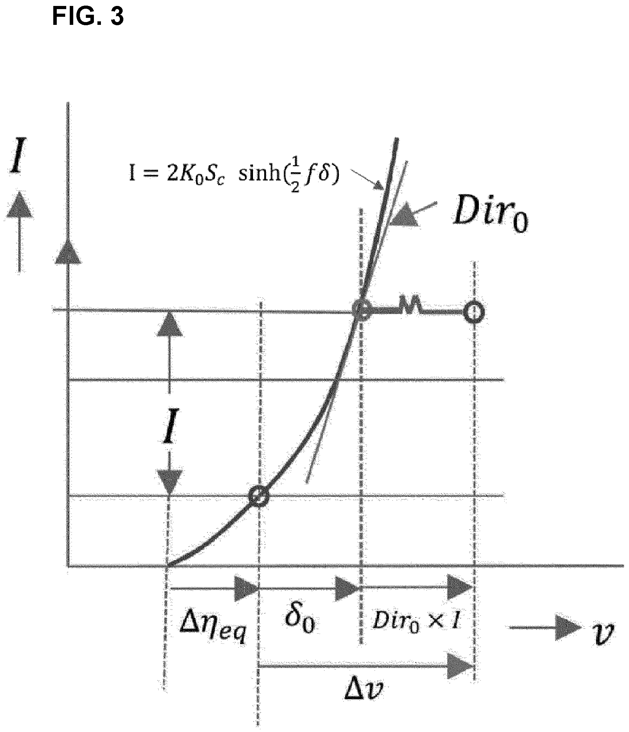

neq* is a potential determined by the concentration ratio of oxidant and reductant at the electrode interface in the stable period, and Δηeq corresponds to the excess of the concentration at the reaction interface required according to the operating current at the time of the operating reaction, which changes the equilibrium potential (see Fig. 3).

The dependence of current I on the very small overvoltage δ serves as the conductance at the operating point, and the reciprocal thereof serves as the resistance, i.e., the dynamic internal resistance Dir at the operating point. This is expressed by the following equation.

[Math. 16]

$$\partial I/\partial \delta = 2K_x S_c \cdot \frac{f}{2}\cosh(\frac{1}{2}f\delta) = \frac{1}{Dir}$$

Further, $K_X$ is changed as follows using [Math. 6].

[Math. 17]

$$K_x = FS_c\sqrt{\kappa^0_{red}\kappa^0_{ox}}\sqrt{c_o(0,t)c_r(0,t)} \approx FS_c\sqrt{\kappa^0_{red}\kappa^0_{ox}}\sqrt{c^*_r c^*_o} \cdot e^{\frac{f}{2}\Delta\eta_{eq}} = K_0 \cdot e^{\frac{f}{2}\Delta\eta_{eq}}$$

The product of the dynamic internal resistance Dir derived from [Math. 16] and the current I derived from [Math. 14] is a function dependent only on the operating overvoltage δ regardless of the battery, as shown in the following [Math. 18].

[Math. 18]

$$Dir \cdot I$$
$$= \frac{2}{f}\tanh(\frac{f}{2}f\delta)$$

By thus setting the elements (δ, Δηeq, Dir, I) for determining the voltage-current characteristics, it is possible to illustrate a schematic diagram showing the characteristics (see Fig. 3) and an equivalent circuit of the battery (see Fig. 4).

[Battery Equation (General Formula)]

During the operation, the electrical double layer described above is formed on the electrode interface by the flow of ions in the electrolyte, and the equilibrium potential of Δηeq shown in Figs. 3 and 4 is added.

Fig. 3 is a voltage-current characteristic diagram during charging.

According to Fig. 3, the terminal voltage Δv at the start satisfies the following expression.

[Math. 19]

$$\Delta v = \delta + \Delta v_2 = \delta + Dir \times I$$

The current equation is as follows.

[Math. 20]

$$I = 2K_0 S_c \ \{\sinh\left(\frac{1}{2}f\left(\Delta\eta_{eq} + \delta\right)\right) - \sinh\left(\frac{1}{2}f\left(\Delta\eta_{eq}\right)\right)$$

Dir at the operating point is obtained by the following equation.

[Math. 21]

$$\frac{\partial I}{\partial\delta} = \frac{1}{Dir} = 2K_0 S_c \frac{1}{2}f \cdot \cosh(\frac{1}{2}f(\Delta\eta_{eq} + \delta))$$

Therefore, the following equation can be obtained.

[Math. 22]

$$Dir_0 \times I = \frac{2}{f}\left[\tanh(\frac{1}{2}f\left(\Delta\eta_{eq} + \delta_0\right) - \frac{\sinh\left(\frac{1}{2}f\left(\Delta\eta_{eq}\right)\right)}{\cosh(\frac{1}{2}f(\Delta\eta_{eq}+\delta_0 ))}\right]$$

This is substituted in [Math. 19] to establish the following "battery equation".

[Math. 23]

$$\Delta v = \delta + \frac{2}{f}\left[\tanh(\frac{1}{2}f\left(\Delta\eta_{eq} + \delta\right) - \frac{\sinh\left(\frac{1}{2}f\left(\Delta\eta_{eq}\right)\right)}{\cosh(\frac{1}{2}f(\Delta\eta_{eq}+\delta ))}\right]$$

Fig. 3 illustrates overvoltage δ.

[Battery Equation (Particular Solution)]

At a rise from the stationary state, the current is expressed by the following equation. Since the electrical double layer in the electrolyte has not been formed on the electrode surface, it is expressed by the general formula wherein $\Delta\eta eq = 0$.

[Math. 24]

$$I = 2K_0 S_c \ \sinh(\frac{1}{2}f\delta)$$

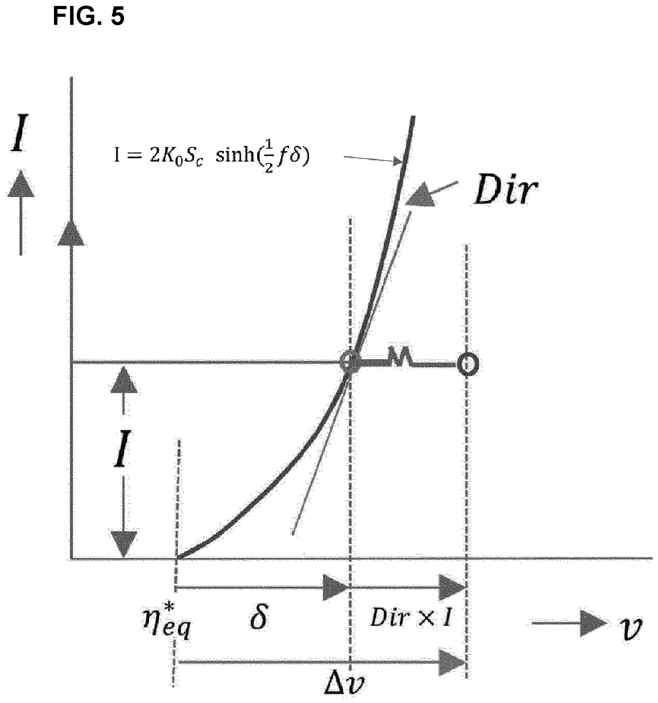

Fig. 5 is a voltage-current characteristic diagram during charging at a rise from the stationary state.
According to Fig. 5, the terminal voltage $\Delta v$ at the start satisfies the following expression.

EP 3 913 726 B1

[Math. 25]

$$\Delta v = \delta + Dir \times I$$

The dynamic internal resistance Dir from the stationary state can be expressed by the following equation.

[Math. 26]

$$\frac{\partial I}{\partial \delta} = \frac{1}{Dir} = 2K_0 S_c \cdot \frac{1}{2} f \cosh(\frac{1}{2} f \delta)$$

[Math. 27]

$$K_0 = F \sqrt{\kappa_{red}^0 \kappa_{ox}^0 \sqrt{c_o^* c_r^*}}$$

The product of Dir and I can be expressed as follows.

[Math. 28]

$$Dir \cdot I = \frac{2}{f} \tanh(\frac{f}{2} f \delta)$$

In conclusion, the following three equations are obtained.

[Math. 29]

$$\Delta v = v - \eta_{eq}^*$$

$$\Delta v_1 = \delta + \frac{2}{f} \tanh\left(\frac{1}{2} f \delta\right)$$

$$\Delta v_2 = \frac{2}{f} \tanh\left(\frac{1}{2} f \delta\right)$$

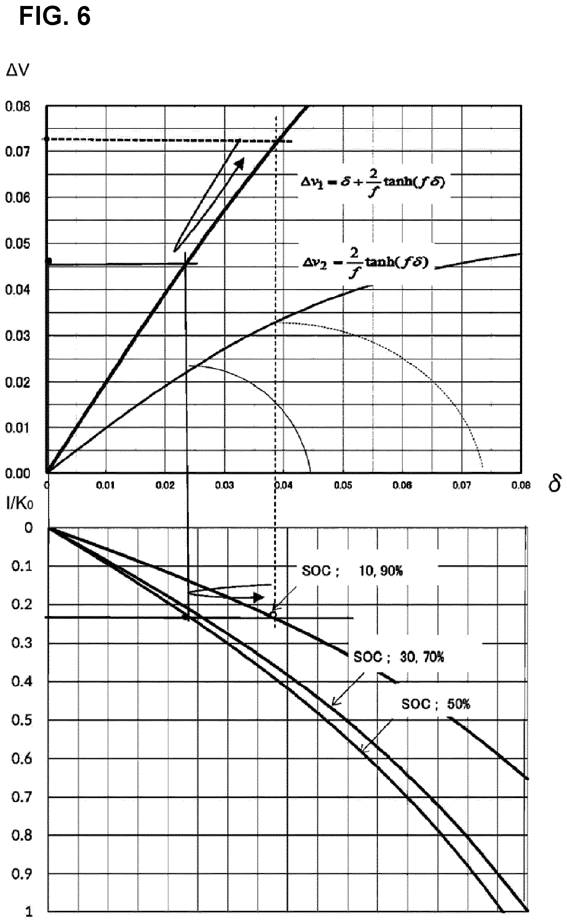

Fig. 6 is a graph drawn by numerical calculation regarding overvoltage δ based on [Math. 29] by assuming that the overvoltage δ is a variable. The graph of Fig. 6 can always be established regardless of the type, size, etc. of the battery.
The horizontal axis in Fig. 6 represents overvoltage δ. The vertical axis of the upper graph in Fig. 6 represents Δv, and the vertical axis of the lower graph in Fig. 6 represents I/Ko, which is described later.
More specifically, the graph of Fig. 6 indicates that when a voltage (electro motive force) of the battery, i.e., a voltage higher than the balanced voltage (neq*) at that time, is applied to the battery, the operating point δ of the battery is set only according to Δv (= v - neq*) regardless of the type of the battery. More specifically, this suggests that the battery reaction of how a battery operates is expressed by the same equation for all kinds of battery, and that the difference in type and performance of a battery exists in that the current and the battery internal resistance depend on this operating point δ.
The graph data (map data) shown in Fig. 6 is stored in a measurement controller 14 of a detection device 1 and a microcomputer 3a of BMU 3, which are described later.

14

[Example of Finding Solution (Example Applying Fig. 6)]

In the actual operation, all of the microcomputer mounted inside the detection device 1 (measurement controller 14) and the microcomputer 3a mounted inside the BMU 3 perform the calculation. A description is given below to explain how each microcomputer goes through a calculation process and presents a calculation result.

Upon the charging of a secondary battery,

1) a current is applied.

2) $\Delta v$ is measured, and an intersection with the curved line graph of $\Delta v_1$ is determined using Fig. 6, and the value of $\delta$ corresponding to the intersection is determined.

3) the current function with respect to $\delta$ has a different coefficient depending on SOC and has a characteristic curve corresponding to SOC as shown in Fig. 6. This can be expressed as follows by changing the form of the coefficient formula.

[Math. 30]

$$K_0 = F\sqrt{\kappa_{red}^0 \kappa_{ox}^0}\sqrt{c_o^* c_r^*} = K_{00}\sqrt{SOC(1 - SOC)}$$

The following equation is obtained from the above equation.

[Math. 31]

$$I/K_{00}S_c = \sqrt{SOC(1 - SOC)} \cdot \sinh(\frac{1}{2}f\delta)$$

This equation is the current equation in Fig. 6.

Therefore, if the SOC at the time of operation is known, the point ($\delta$, $I/K_{O\,O}Sc$) passing through the intersection of ($I/K_{O\,O}Sc$) depending on the type of electrode is determined from the intersection, and this point can be regarded as an operating point corresponding to SOC.

If the right side of [Math. 31] is determined, the characteristic value $K_{O\,O}$ specific to the battery type and the effective electrode surface area Sc are determined by introducing the measured current I in the left side.

In the characteristic diagram shown in Fig. 6, the current value I with respect to overvoltage $\delta$ greatly varies depending on the charging state (i.e., SOC). More specifically, when the SOC is small, the overvoltage $\delta$ is large in order to obtain a constant current value. As the charging proceeds, the overvoltage $\delta$ becomes minimum when the SOC is around 50%, and the overvoltage $\delta$ increases again as the charging further proceeds. In the charging process from "EMPTY" to "FULL" of the battery, the operating point changes along the arrow shown in Fig. 6. If the SOC can somehow be fixed to 50%, and if the current I and $\delta$ are fixed according to the SOC = 0.5 curve in Fig. 6, [Math. 12] is expressed as follows.

[Math. 32]

$$K_0 S_c = FS_c\sqrt{\kappa_{red}^0 \kappa_{ox}^0} \cdot \frac{1}{2}$$

According to this equation, the SOH serving as the battery performance index indicating the current performance of the battery is determined, and the SOH serving as the battery performance index is determined according to the chart shown in Fig. 6.

The description above is the principle for the detection of the state of health and the state of charge of a secondary battery based on the "battery equation".

The correlation between the mathematical formula analysis described above and the qualitative phenomenology is described below for reference.

[Battery Electro Motive Force and Dynamic Internal Resistance]

Fig. 4 is an electrical equivalent circuit showing the concept of charging.
The following describes battery electro motive force Vemf and dynamic internal resistance Dir using the equivalent circuit of a battery (the secondary battery 10 in the present embodiment) shown in Fig. 4.
A battery is a simple electric circuit when it is expressed by an equivalent circuit. More specifically, a battery is expressed by a series connection of a battery element having a charge amount (storage capacity) Q (unit: coulomb), which is electric energy, and a pure resistor (conductance) directly connected to the battery. Specifically, as shown below, when the voltage between the battery terminals (A-B) is represented by V, the current flowing between the battery terminals (A-B) is represented by I, the dynamic internal resistance is represented by Dir, and the battery electro motive force is represented by Vemf, the battery can be expressed by an equivalent circuit as shown in Fig. 4.

V: voltage between battery terminals (A-B)
I: current flowing between battery terminals (A-B)
Dir: Dynamic Internal Resistance
Vemf (= $\eta$eq*): battery electro motive force (potential difference between a positive electrode and a negative electrode in a stationary state)

The battery electro motive force Vemf means a voltage between the battery terminals (A-B) in a state where the battery is not connected to an external circuit and no current flows (stationary state). For example, in the case of a lithium-ion battery, which is an example of a secondary battery, the battery electro motive force Vemf is not a flow of lithium ions $Li^+$ or electrons $e^-$, but is an ion potential difference between a cathode and an anode. Therefore, the ion potential difference is represented by a difference in ratio of sites occupied by lithium ions $Li^+$ between the cathode and the anode.
For example, in the case of a lithium-ion battery, the storage capacity Q means the size of a space in which lithium ions $Li^+$ are stored in the negative electrode. More specifically, a large storage capacity Q indicates large volumes of the negative electrode and the positive electrode (a large number of sites) (the $K_O$ value of [Math. 32] is large). It also means that the action surface is large (the Sc value of [Math. 32] is large), and the permeation of lithium ions $Li^+$ into both electrodes is fast and large.
The storage capacity Q decreases with the deterioration of the secondary battery 10. The deterioration of the secondary battery 10 means that the dynamic internal resistance Dir increases and the lithium ions do not come into contact with the battery electrodes and thus do not function. The cause of the increase in dynamic internal resistance Dir is presumably, for example, an increase in resistance in electrophoresis of lithium ions, a decrease in reaction speed, a decrease in diffusion speed, a decrease in number of sites for lithium ions in the anode and the cathode, and the like. The dynamic internal resistance Dir increases as charging and discharging are repeated, and as a result, deterioration of the secondary battery 10 proceeds.
The dynamic internal resistance Dir derives from a battery reaction, and decreases as the reaction area enlarges. The battery capacity Q increases as the reaction area enlarges. The following specifically describes the relationship between the storage capacity Q and the dynamic internal resistance Dir.

<Relationship Between Storage Capacity and Dynamic Internal Resistance>

The following explains a simplified concept of the relationship between the storage capacity Q and the dynamic internal resistance Dir.
When the micro action surface element as a counter element of the negative and positive electrodes is represented by dS, the battery element can be represented by an equivalent circuit using dS.
The conductance $\rho$, which indicates the easiness of flow of the current in the circuit per unit action surface area, is expressed as:

$$P = 1/r$$

wherein r represents the resistance per unit area, and the dynamic internal resistance Dir is expressed by the following formula:

$$Dir = 1/\int \rho \, dS = 1/\rho \, S = r/S \dots (a)$$

wherein S represents an effective working surface area (reaction surface area).

Further, the storage capacity Q of the entire area is expressed as:

$$Q = \int q dS = qS \ldots (b)$$

wherein q represents an electric capacity per unit area.

From the above formulas (a) and (b), the following relationship:

$$Dir \times Q = qr = K \ldots (c)$$

is obtained. In the equation, K is a constant (a certain value) unique to the type of secondary battery.

More specifically, in the secondary batteries of the same type having different storage capacities Q, since the value obtained by multiplying the storage capacity Q by the dynamic internal resistance Dir is constant as in the above equation (c), the dynamic internal resistance Dir is inversely proportional to the storage capacity Q and therefore decreases in a battery having a large storage capacity Q, and the storage capacity Q is inversely proportional to the dynamic internal resistance Dir and therefore decreases when the dynamic internal resistance Dir increases. As the effective working surface area S decreases, the storage capacity Q decreases while the dynamic internal resistance Dir increases. Therefore, by calculating the dynamic internal resistance Dir, the storage capacity Q can be calculated using the K value.

The dynamic internal resistance herein refers to Dir obtained from the battery equation according to the present embodiment.

[Specific Embodiment of SOH/SOC Detecting Device for Secondary Battery]

A SOH/SOC detecting device 1 for a secondary battery 10 (also simply referred to as a detection device 1 in the present embodiment) is described below as one embodiment of the present invention with reference to the drawings. The secondary battery 10 refers to a battery that can be repeatedly charged and discharged, and that can convert electrical energy into chemical energy and store the chemical energy, and conversely, convert the stored chemical energy into electrical energy and use the electrical energy. Examples of the secondary battery 10 include a nickel-cadmium battery, a nickel-hydrogen metal battery, and a lithium-ion battery.

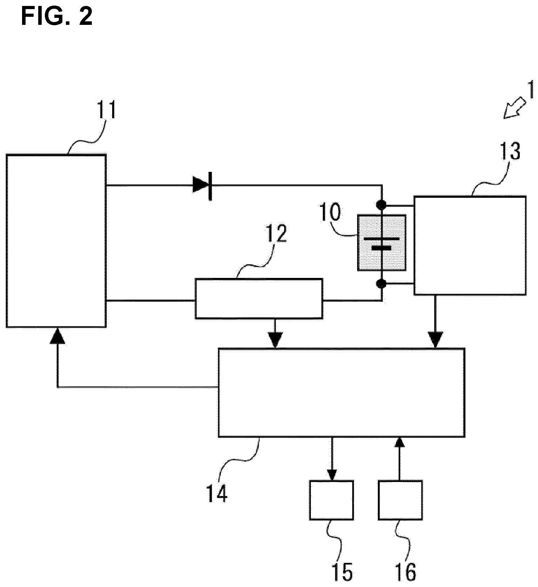

Fig. 2 shows a fundamental structure of the detection device 1. The detection device 1 mainly includes a power supply unit 11 that supplies a charging voltage to the secondary battery 10, a current detector 12 that serves as a charging current measuring means, a voltage detector 13 that serves as a voltage measuring means, a measurement controller 14, a display means 15, an operation switch 16, and the like. The measurement controller 14 is electrically connected to the power supply unit 11, the current detection circuit 12, the voltage detector 13, the display means 15, the operating means 16, and the like.

The structure of the detection device 1 described in the present embodiment may be any configuration insofar as it enables the functions described in the present embodiment; the structure can be modified as appropriate. The secondary battery 10 is connected to the power supply unit 11 via the current detector 12.

The power supply unit 11 includes a transformer/rectifier circuit that converts commercial alternating-current power into direct-current power. The power supply unit 11 serves as a power source and supplies an output voltage of, for example, about 1.2 times the rated voltage of the secondary battery 10, thereby supplying a current of about 0.1C or more of the battery capacity. The power supply unit 11 has an external voltage control terminal (not shown) and is connected to the secondary battery 10 via the external voltage control terminal.

The voltage detector 13 measures the voltage of the secondary battery 10, and detects an inter-terminal voltage between the positive electrode (+) and the negative electrode (-) of the secondary battery 10 (this voltage is also referred to as a terminal voltage).

The current detector 12 and the voltage detector 13 constitute a measuring means for measuring voltages and currents of the secondary battery.

The measurement controller 14 includes a microcomputer or a PC (personal computer) including a central arithmetic device, a storage means (ROM, RAM, HDD, or the like), various kinds of I/F, and the like. The measurement controller 14 is capable of storing the measurement principle and calculations described in the present embodiment as a program, and is also capable of executing the program. That is, the measurement controller 14 includes a calculating means for executing the predetermined calculations. More specifically, the measurement controller 14 includes a current detection unit that detects a current value applied to the secondary battery 10 via the current detector 12, a voltage detection unit that detects a voltage value between the respective terminals of the secondary battery 10 via the voltage detector 13, an AD conversion unit that converts an analog signal detected by the current detection unit and the voltage detection unit into a digital signal, and the like. The storage means such as ROM stores various processing programs to be performed in the detection device 1 (for example, a program for following the measurement principle of the method for detecting the SOH and the SOC described in the present embodiment and performing the predetermined calculations using the detected voltage/current data), and the like.

The display means 15 displays information indicating the charging state of the secondary battery 10 (for example, the state of deterioration, etc.). The display means 15 is constituted of an LCD or the like. The display means 15 is capable of displaying, for example, the battery electro motive force Vemf, the dynamic internal resistance Dir, the state of health SOH (State of Health), and the state of charge SOC (State of Charge) as information indicating the charging state of the secondary battery 10.

The operating means 16 is a means by which a user performs an operation or the like to execute detection of the SOH and the SOC. The operating means 16 is, for example, an operation switch, a touch panel of a liquid crystal or the like, or a keyboard.

As shown in Fig. 2, the secondary battery 10 is connected to the power source 11 via the current detector 12. Then, the voltage and current signals respectively measured by the voltage detector 13 for measuring voltages of the secondary battery 10 and the current detector 12 for measuring charging currents of the secondary battery 10 are transmitted to the measurement controller 14. The measurement controller 14 receives the signals, performs calculation, controls the output voltage and current of the power source 11 so that they have appropriate values, and outputs the numerical values of SOC and SOH as the calculation results, i.e., displays the numerical values in the display means 15.

Fig. 7 is a diagram showing time characteristics of rise and fall of voltage-current.

Fig. 7 illustrates a time-dependent change in voltage-current after the charging operation is started at t = 0 in the case of constant current control. When an overvoltage $\delta$ higher than the electro motive force (balanced voltage) is applied, the constant value of the current becomes I and the battery terminal voltage becomes v.

The overvoltage $\delta$ and the dynamic internal resistance Dir are calculated from the measured value $\Delta v$ obtained with respect to the set value I of the current according to the equation of [Math. 23] or [Math. 25], and the capacity of a new cell of the same type is determined from a Dir ratio using data of dynamic internal resistance Dir and capacity Q measured from "EMPTY" to "FULL" in advance, as well as SOC and $\eta eq^*$ (= Vemf). The time required for this operation is calculated based on the measurement principle described above; therefore, the performance of the battery can be immediately determined within a second.

[Calculation of SOH (State of Health)]

The state of health SOH, which is an index indicating the progress of deterioration of the secondary battery 10, is described below.

In the detection device 1 of the present embodiment, the measurement controller 14 calculates the SOH, which is a state of health indicating the deterioration state of the secondary battery 10 with respect to the charging/discharging cycle. The SOH is an index indicating the progress of deterioration of the battery, and is expressed by a ratio of the current storage capacity to the initial storage capacity. When the initial storage capacity is $Q_O$, the SOH can be calculated according to SOH = $(Q/Q_O) \times 100$.

As for the state of charge SOC, if the battery electro motive force Vemf can be accurately obtained by the measurement principle described above or the like, the obtained electro motive force can be defined as a voltage at which the state of charge of the secondary battery 10 is 100%.

In the detection device 1, the measurement controller 14 calculates the current storage capacity Q, SOH, and SOC of the secondary battery 10, and these parameters are output to the display means 15 to be displayed.

[Method 1]

As described above, in the detection device 1 of the present embodiment, the measurement controller 14, which is an example of the control unit, is capable of calculating the overvoltage $\delta$ during the operation of the secondary battery 10 and Dir according to the battery equation of [Math. 25] and the equation of [Math. 28] based on the measured values of the rising voltage and the current at the start of charging of the secondary battery 10. Further, the state of health SOH can be detected by comparing the obtained Dir with the Dir of a brand-new secondary battery. This enables accurate and instantaneous detection of the SOH of the secondary battery 10. Therefore, the battery state (for example, the charging state) of the secondary battery 10 can be recognized whenever necessary.

[Method 2]

Further, in the detection device 1 of the present embodiment, the measurement controller 14 determines an accurate change in electro motive force at the stationary state based on the measured value of the fall voltage at the

time when the charging of the secondary battery 10 is blocked, $\Delta\eta eq$ and $\eta eq^*$ obtained from [Math. 9] to [Math. 11], and the "battery equation", and determines the state of charge SOC by referring to a comparison table having a previously-measured electro motive force. As a result, even if the capacity of the secondary battery 10 decreases due to long-term use, the state of charge at that time can be acquired as a ratio and as an absolute value. This will alleviate user's anxiety about energy depletion.

Further, according to the detection device 1 of the present embodiment, the measurement controller 14 determines the dynamic internal resistance Dir during charging based on the measured value of the voltage by the voltage detector 13 and the battery equation shown in [Math. 23], and calculates the state of health SOH from the minimum Dir obtained by determining the minimum value of Dir by referring to the state of charge SOC. This enables accurate and instantaneous detection of SOH of the secondary battery 10. Therefore, the battery state (for example, the deterioration state) of the secondary battery 10 can be recognized whenever necessary.

Furthermore, according to the detection device 1 of the present embodiment, the measurement controller 14 obtains the battery capacity of the secondary battery 10 by determining the battery-specific coefficient (see [Math. 31]) that determines the voltage-current characteristic with respect to overvoltage $\delta$ based on the measured value of the voltage by the voltage detector 13 and the battery equation shown in [Math. 23].

More specifically, a specific measure to achieve this is determining the coefficient $K_O$ of the current-voltage curve by applying Fig. 6, and determining the capacity Q by multiplying the K value by the power storage element capacity $Q_O = 0.55$ (this numerical value is calculated under the optimum charging condition based on the electrochemical reaction theory) of the battery reaction based on the principle of the oxidation-reduction chemical reaction. As the detection device 1 described above performs this operation by calculation, the time required for the operation is only one second or less. Thus, the performance determination can be immediately made. Although this method has a drawback of having an error in power storage element capacity, which is about $\pm$ 10%, the error can be minimized by the [Method 1] described above.

[Practical Development of the Present Invention]

The SOH/SOC detecting device for a secondary battery according to the present invention is expected to provide the following advantageous effects.

(1) The performance of the battery depends on the performance of electrodes (negative electrode and positive electrode) responsible for the oxidation-reduction reaction. The present invention determines the electrode performance in a short time by measuring voltage and current values applied from the outside of the battery and performing calculation using the measured values. Such a detection of electrode performance ensures safety and reliability in use of batteries.

(2) The working medium (for example, lithium ions in a lithium-ion battery) in a battery generally contains its medium in a dissolved form in a polymer dielectric, and a flow is formed during the charging/discharging process. The degree of the flow is also largely involved in the battery performance. As in (1), the degree may also be obtained as a numerical value based on the measurement of external voltage/current, and the quality thereof can be determined.

3) The life of a battery is limited due to deterioration. The battery life can be predicted by data analysis of measurement results over time given by the SOH/SOC detecting device for a secondary battery of the present invention. This is because the present invention makes it possible to obtain data rapidly and accurately.

In using a secondary battery, it is indispensable to always grasp the current state of charge (SOC) and the state of health (SOH, power storage performance). However, in prior art, it has been impossible to immediately detect the state of the battery, and there were many cases causing unexpected "depletion of electricity" or "overcharging", as well as various troubles or hazards.

The SOH/SOC detecting device for a secondary battery according to the present invention was created as a "battery analyzer" capable of accurately measuring the quality and performance of a battery in less than one second by analyzing the flow of electrons at the time of oxidation/reduction in an electrode in relation to the chemical reaction inside a battery having a complicated mechanism and the continuity of the flow of electrons flowing in an external circuit, based on a rather classical method of the chemical reaction theory, summarizing the analysis as the universal "battery equation" described above, and further developing the application and adaptation.

The technology according to the present invention may be applied to all stages of battery utilization and application, thereby achieving, for example, rapid evaluation upon the battery development, quality control upon the battery production, adjustment of individual cell performance upon the production of battery packs, recognition of the operation state of a battery system, performance classification at the time of reuse, and the like.

In Method 1 described above, the detection device 1 calculates the overvoltage $\delta$ and the Dir during the operation of the secondary battery 10 based on the "measured values of the rising voltage and current at the start of charging" of the secondary battery 10 using the battery equation of [Math. 25] and the equation of [Math. 28]. The "measured values of rising voltage and current at the start of charging" herein is an example of the "predetermined condition regarding charging or discharging" of a secondary battery acquired by the measurement controller 14 via various measuring means.

Examples of the "predetermined conditions regarding charging or discharging" include:

(1) Time course of the fall voltage at the start of discharging
(2) Measured value of the rising voltage when discharging is blocked
(3) Measured value of the rising voltage when the charging current is increased or when the discharging current is decreased
(4) Time course of the fall voltage when the charging current is decreased or when the discharging current is increased
(5) Time course of the fall voltage in the transition from charging to discharging
(6) Measured value of the rising voltage in the transition from discharging to charging

The detection device 1 is capable of determining the overvoltage $\delta$ during the operation of the secondary battery 10 and Dir by calculation using the battery equation of [Math. 25] and the equation of [Math. 28] based on these conditions. Therefore, the same effects as those of the present invention are exerted.

Although charging and discharging in the case of using a secondary battery have been described in the present embodiment, the present invention is not limited to secondary batteries, and can be applied to a wide range of power storage elements.

A power storage element refers to any element having a power storage function, and refers to, for example, an element including at least a pair of electrodes and an electrolyte and having a function of storing power. The power storage element may be a power storage device.

Examples of power storage element include secondary batteries such as lithium ion secondary batteries, lead-acid storage batteries, lithium ion polymer secondary batteries, nickel-hydrogen storage batteries, nickel-cadmium storage batteries, nickel-iron storage batteries, nickel-zinc storage batteries, and silver oxide-zinc storage batteries; liquid circulation secondary batteries such as redox-flow batteries, zinc-chlorine batteries, and zinc-bromine batteries; and high-temperature operation secondary batteries such as aluminum-air batteries, zinc-air batteries, sodium-sulfur batteries, and lithium-iron sulfide batteries. However, the present invention is not limited to the examples listed above. For example, the power storage element may be formed using a lithium ion capacitor, an electrical double layer capacitor, or the like.

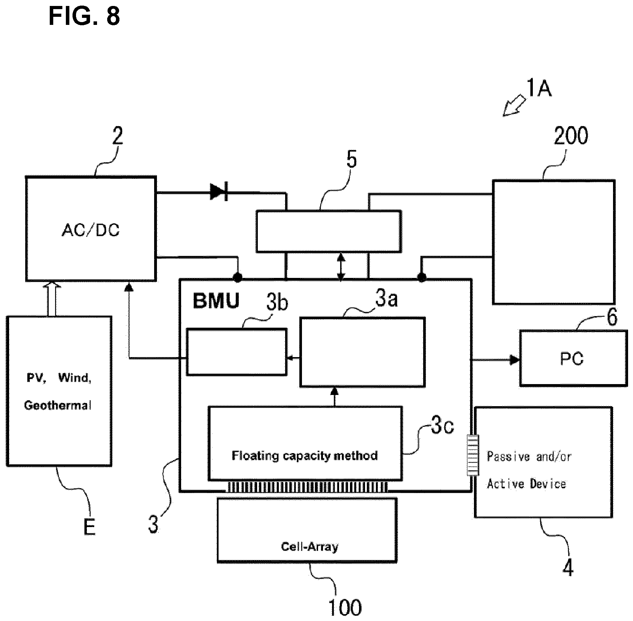

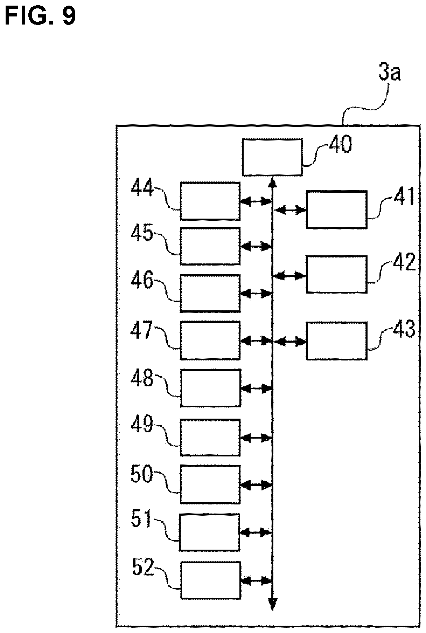

A charging device 1A including a battery management system (BMS) having a battery management unit according to one embodiment of the present invention is described below with reference to Figs. 8 and 9. The charging device 1A stores electric power generated by various types of energy source E in a secondary battery 100, which is an example of a battery system, via a charging power source 2, and supplies the electric power from the secondary battery 100 to a load 200. The charging device 1A is electrically connected to the load 200 that operates using the electric power stored in the secondary battery 100. Examples of the energy source E include PV, wind power, and geothermal power. Examples of the load 200 include power sources such as a motor, various devices, lighting devices such as an electric lamp, and a display device for displaying information or the like.

The battery system according to the present embodiment is obtained by connecting a plurality of cells in series to form a pack and a module to constitute a battery pack.

In the present embodiment, the present invention is specifically explained by describing a secondary battery including a single cell or a battery pack, as an example of the power storage element.

The secondary battery 100 according to the present embodiment refers to a battery that can be repeatedly charged and discharged, and that can convert electrical energy into chemical energy and store the chemical energy, and conversely, convert the stored chemical energy into electrical energy and use the electrical energy. Examples of the secondary battery 100 include a nickel-cadmium battery, a nickel-hydrogen metal battery, a lithium-ion battery, and a lead battery. Among these, lithium-ion batteries with a high energy density are particularly preferable to be used for the secondary battery 100.

As shown in Fig. 8, the charging device 1A mainly includes an energy source E, a charging power source 2, a battery management unit (hereinafter referred to as BMU) 3 that monitors and controls the secondary battery 100, a balance mechanism 4, a current detection/protection circuit 5, and a display means 6. The charging device 1A is electrically connected to the secondary battery 100, which is a battery system, and a load 200. The BMU 3 is electrically connected to the charging power source 2, the balance mechanism 4, the current detection/protection circuit 5, the display means 6, the secondary battery 100, and the load 200.

Each of the charging device 1A, the BMU 3 included in the charging device 1A, and the secondary battery 100 connected to the BMU 3 described in this embodiment may have any structure insofar as the functions described in the present embodiment can be implemented. Their structures can be modified as appropriate.

The charging power source 2 is a power source that supplies a charging voltage to the secondary battery 100.

The charging power source 2 includes a transformer/rectifier circuit that converts alternating-current power into direct-current power. The resulting direct-current power is supplied to the secondary battery 100 via the BMU 3.

The BMU 3 includes a microcomputer 3a as a control circuit (processor), which is an example of a control unit that mainly executes calculations, commands, and the like, a charging voltage control unit 3b that controls a charging voltage and the like, and a cell voltage detection circuit 3c that detects a voltage of each cell of the secondary battery 100. The BMU 3 measures a voltage of each cell of the secondary battery 100.

The microcomputer 3a is electrically connected to the charging voltage control unit 3b and the cell voltage detection circuit 3c. The microcomputer 3a includes a microprocessing unit (MPU, hereinafter) 40 as a central arithmetic device, a read only memory (ROM, hereinafter) 41 and a random access memory (RAM, hereinafter) 42 as memory means, a switching control unit 43 that controls ON/OFF of a switching element (not shown) included in the cell voltage detection circuit 3c, a timer 44 as a time measuring means, a counter 45 as a counting means, a current detection unit 46 that detects a current value applied to the secondary battery 100 during charging or discharging via a current detecting means (a current sensor 60 described later), a cell voltage monitoring unit 47 that monitors a voltage value (cell voltage) between terminals of each cell of the secondary battery 100, an A/D conversion unit 48 having an A/D conversion function, a state of health calculation unit 49 that calculates a state of health SOH of the cell, a dynamic internal resistance measurement unit 50, a dynamic internal resistance storage unit 51, a temperature correction value acquisition unit 52, and the like. The ROM 41 stores various processing programs (for example, programs for detecting voltages of individual cells included in the secondary battery 100 and controlling voltages and currents applied during the charging and discharging according to the state) to be performed in the charging device 1A. In the RAM 42, for example, the graph according to the present embodiment, an approximation related to the graph, and the like are stored. The microcomputer 3a is a control circuit including the switching control unit 43, and controls ON/OFF of the switching element.

The details of the SOH calculation unit 49, the dynamic internal resistance measurement unit 50, the dynamic internal resistance storage unit 51, and the temperature correction value acquisition unit 52 are described later.

The balance mechanism 4 is a balance means having a function of maintaining a voltage balance between the cells of the secondary battery 100, and is configured by, for example, an IC chip having such a function. The balance mechanism 4 is operated by, for example, the microcomputer 3a of the BMU 3. The balance mechanism 4 compares voltages of a plurality of cells with each other, independently discharges or appropriately charges each cell with a constant current as necessary, thereby standardizing the SOC (State of Charge) level of each cell. More specifically, the balance mechanism 4 constitutes a charging/discharging circuit for adjusting the voltage balance between the respective cells of the secondary battery 100 through discharging or charging.

The current detection/protection circuit 5 is a protection circuit for detecting current values of charging currents and discharging currents, and also for stopping overcharging and over discharging. The current detection/protection circuit 5 measures a voltage by an electronic circuit, and stops charging when the voltage becomes equal to or higher than a certain value. The current detection/protection circuit 5 also stops discharging when the voltage becomes equal to or lower than a certain value. The current detection/protection circuit 5 is operated by the microcomputer 3a of the BMU 3.

The display means 6 displays the charging state (SOC or the like) of the secondary battery 100, the total voltage of the battery, the voltages of individual cells, and the like in real time. The display means 6 includes, for example, a predetermined display device, an LCD of a personal computer (PC), or the like.

The secondary battery 100 is an example of a battery system in which a plurality of cells (single cell inducing a basic battery reaction) are connected in series to increase the voltage to constitute an energy source. The secondary battery 100 is a battery pack constituted of a plurality of cells connected in series, in which the cells are electrically accumulated to increase the voltage. Examples of the secondary battery 100 include lithium-ion batteries.

[Cell Voltage Detection Circuit]

The voltage detection method and data processing method described in Japanese Patent Application Publication No. 2017-66404 filed by the inventor of the present invention may be applied to the methods for detecting the voltage and processing data of each cell of the secondary battery 100 by the BMU 3 (cell voltage detection circuit 3c).

The cell voltage detection circuit 3c is an example of the voltage measuring means for measuring a voltage between terminals of a cell as a power storage element. The voltage measuring means may measure the voltage of a cell, for example, by a resistance division type circuit or the like.

The microcomputer 3a has a cell protection function of operating the current detection/protection circuit 5 based on the results of all the voltage values of the cells, and immediately stops charging when the voltage of one of the cells constituting the secondary battery 100 exceeds a predetermined voltage limit, and immediately stops discharging when the voltage of one of the cells falls to a predetermined lower voltage limit. Further, it is also possible to add a blockage relay for blocking power supply to the load 200 as a function of the secondary battery 100. In this configuration, a stop signal for stopping them from the microcomputer 3a is used as a drive signal of the blockage relay to block the power.

More specifically, the microcomputer 3a is capable of controlling the charging voltage of the charging power source 2 for charging the secondary battery 100 according to the voltage of each cell, thereby optimizing the charging and discharging operations of the entire secondary battery 100.

In addition, the microcomputer 3a is capable of observing the degree of variation in voltage of each cell, adjusting the current intensity of charging, reducing the discharging current, automatically adjusting the adaptability of the load power according to the power of the secondary battery 100, thereby preventing the abnormal operation of the secondary battery 100. In addition, the BMU 3 also provides a function of ensuring stability and a long life of the battery.

Further, for example, by providing each cell of the secondary battery 100 with a fixed resistance load via a control relay, the voltages of all cells can be unified to have the minimum value of the cells, thereby providing so-called a passive cell balance function.

The passive cell balance means that a cell having a high voltage is discharged to make its voltage equal to the value of a cell having a low voltage.

Further, for example, by providing each cell of the secondary battery 100 with an individual power source via a control relay, it is possible to perform supplementary charging that unifies the voltages of all cells to have the maximum value of the cells, thereby providing so-called an active cell balance function.

The active cell balance means that a cell having a low voltage is charged to make its voltage equal to the value of a cell having a high voltage. The following charging method may also be used to provide the active cell balance function of the BMU 3 according to the present embodiment.

[Diagnosis Method During Charging/Discharging: Calculation of state of health SOH of Power Storage Element (Cell)]

The BMU 3 according to the present embodiment has a diagnostic function of calculating the state of health SOH of a power storage element (cell). The function is described below.

The BMU 3 (microcomputer 3a) includes a SOH calculation unit 49 that calculates the state of health SOH of a cell based on the dynamic internal resistance Dir of the cell in a brand-new state and the current dynamic internal resistance Dir, a dynamic internal resistance measurement unit 50 that measures the current dynamic internal resistance Dir of the cell while charging or discharging the cell, and a storage unit 51 that stores the dynamic internal resistance Dir of the cell in the brand-new state.

The diagnosis of each cell of the secondary battery 100 by the BMU 3 is performed by measuring a voltage change during charging of the cell or a voltage change during discharging of the cell.

Further, as described above, since the progress of deterioration of a cell can be expressed as a change rate of the dynamic internal resistance Dir of the cell, the state of health SOH of the power storage element (cell) can be expressed as: (Dir of a power storage element in a brand-new state)/(current Dir of the power storage element) × 100 (%).

Therefore, when the SOH calculation unit 49 calculates the state of health SOH of a cell, the BMU 3 calculates Dir of a cell in a brand-new state in the manner described below and stores the calculated Dir in a predetermined dynamic internal resistance storage unit 51, and compares the Dir of the cell in a brand-new state stored in the dynamic internal resistance storage unit 51 with the Dir of the cell currently being diagnosed (being charged or discharged) measured by the dynamic internal resistance measurement unit 50. In this manner, the deterioration state of the cell can be determined, thereby detecting SOH or full charging capacity.

The current Dir of the cell is measured by the dynamic internal resistance measurement unit 50 based on the principle described above.

It is necessary to store the Dir of a cell in a brand-new state in the dynamic internal resistance storage unit 51 in advance; however, the Dir is not constant and changes depending on a difference in SOC (electro motive force Vemf). The method for calculating the Dir of a cell in a brand-new state is described below.

In order to calculate the Dir of a cell in a brand-new state, it is necessary to detect the SOC (electro motive force Vemf) of the corresponding cell at present.

The electro motive force Vemf can be determined by measuring the voltage after stopping charging and discharging of the cell and leaving the cell unattended for a while. However, since a BMS needs to perform diagnosis even during the charging and discharging, the measurement method for that purpose is described below.

(Calculation of Vemf During Charging and Discharging)

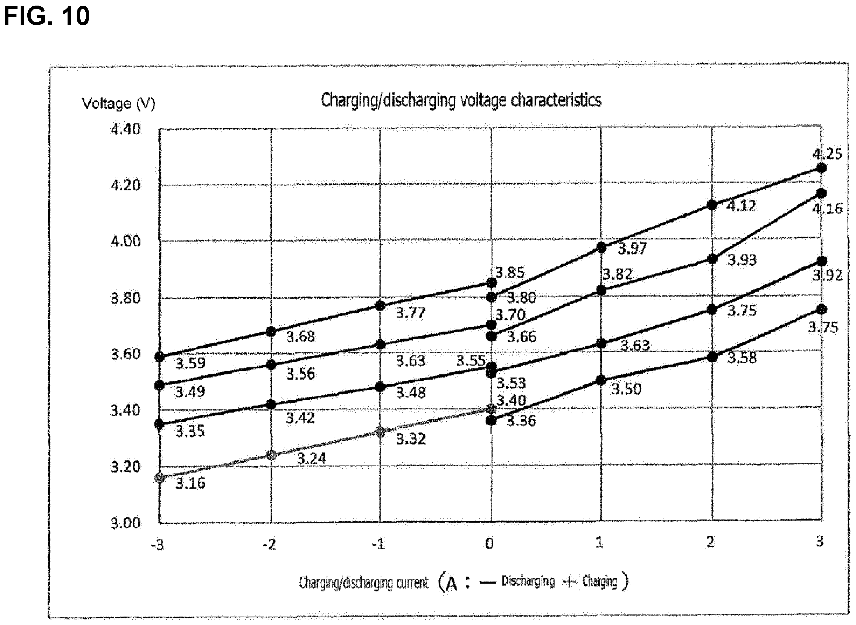

Fig. 10 shows charging and discharging currents flowing through a power storage element (cell), as well as changes in terminal voltage due to charging and discharging. In the graph of Fig. 10, measurements were performed under four different Vemf conditions.

Although the inclinations during charging slightly vary for the charging and discharging currents on the positive side, Vemf can be determined from the terminal voltage during charging and discharging according to the following equation of an approximation straight line by assuming that the inclinations are identical regardless of the value of Vemf.

The graph of Fig. 10 derives the following approximation where V0 represents a terminal voltage and I represents a charging/discharging current (+: charging, -: discharging).

During discharging: Vemf = V0 - 0.08I (I<0)

During charging: Vemf = V0 - 0.151 (0<I).

By thus deriving an approximation, the electro motive force Vemf can be determined by measuring the terminal voltage of the cell and the current (charging/discharging current) by the current sensor 60.

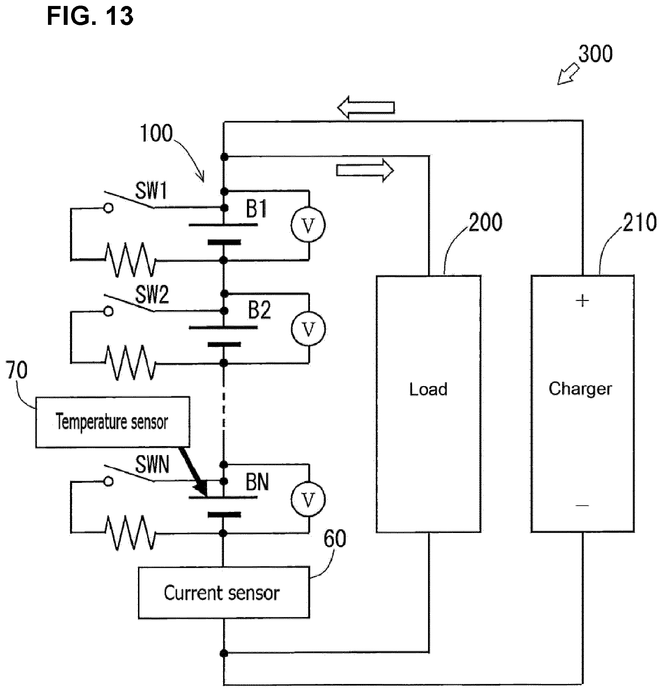

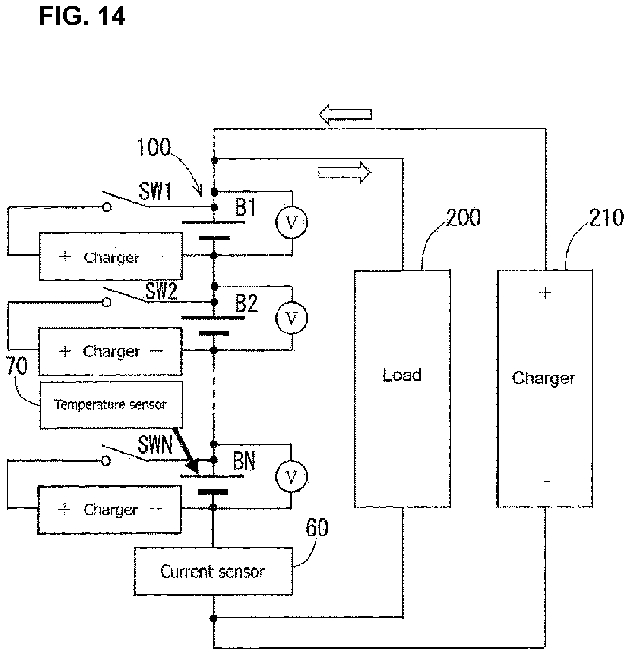

The current sensor 60 (see Figs. 13 and 14) for measuring a current flowing during charging or discharging is provided for each cell of the secondary battery 100.

[Dir Initial Characteristics: Calculation of Dir of Power Storage Element in a Brand-New State from Vemf]

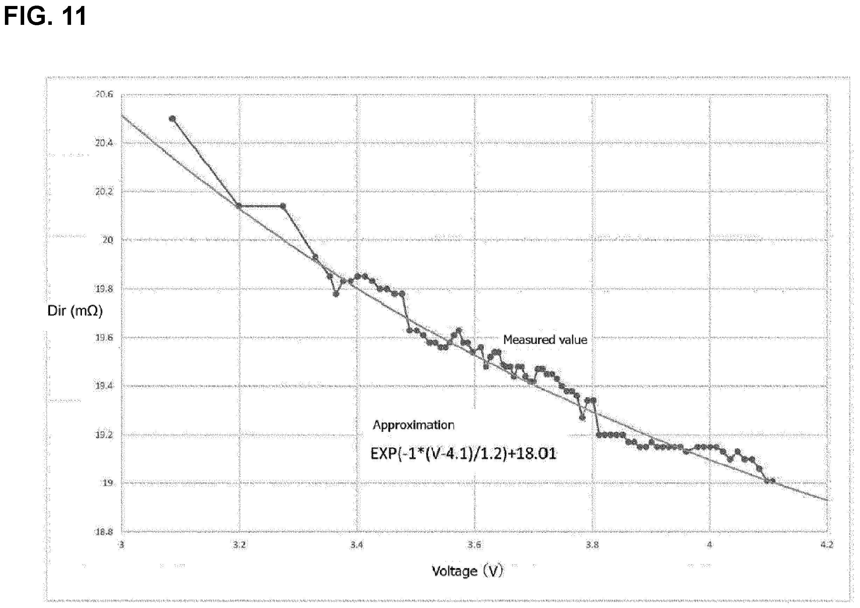

Fig. 11 is a graph plotting the voltage (electro motive force Vemf) during charging and discharging calculated as described above and the measured Dir with respect to the voltage.

The initial Dir (Dir of a cell in a brand-new state) can be determined by substituting the electro motive force Vemf into V in a predetermined approximation that approximates the plotted value (for example, the approximation in the graph of Fig. 11). Fig. 11 reveals that the Dir of a cell is not a constant value; in fact, it decreases as the charging proceeds.

The BMU 3 of the present embodiment is thus capable of accurately detecting the Dir initial characteristic, thereby further improving the accuracy of the SOH as compared with the existing technologies.

[Temperature Correction of Dir of Power Storage Element in Brand-New State]

The BMU 3 of the present embodiment has a function of correcting Dir according to the temperature of the cell. The function is described below.

The BMU 3 (microcomputer 3a) has the temperature correction value acquisition unit 52 that acquires a temperature of a cell by the temperature sensor 70, which is a temperature measuring means, and, based on a relationship between the temperature of the cell and the dynamic internal resistance Dir of the cell in a bland-new state stored in advance, acquires a dynamic internal resistance Dir of the cell in a brand-new state corresponding to the temperature of the cell. In other words, the temperature correction value acquisition unit 52 is a temperature correction means for performing correction of Dir according to temperature.

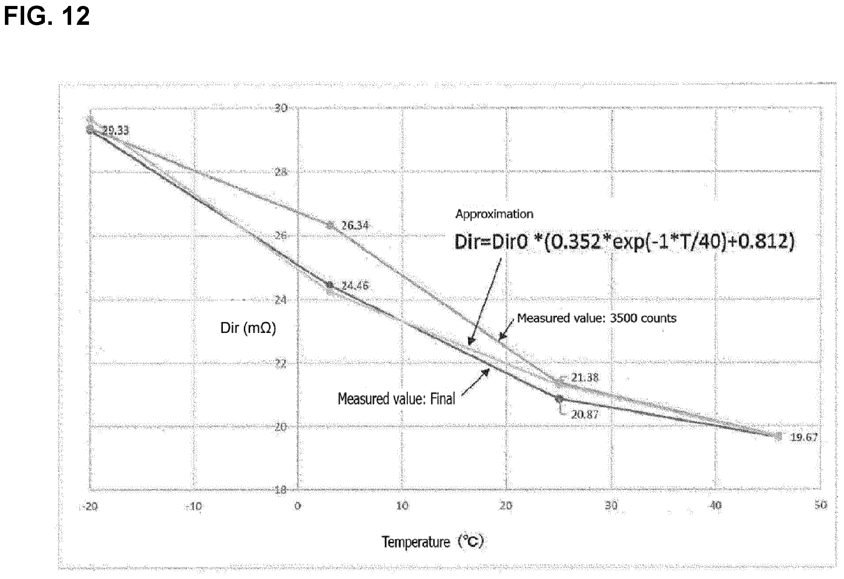

The graph shown in Fig. 12 is a measurement result obtained by actually measuring the Dir variation (temperature dependency) due to the temperature change in advance. As shown in the graph, the Dir changes with a change in ambient temperature. Further, using the relational expression (approximation) of this graph enables determination of the Dir of the cell in a brand-new state when the temperature of the cell changes. By thus using Dir of a brand-new state of the cell that has been corrected according to the temperature, the BMU 3 calculates the state of health SOH of the cell. The BMU 3 of the present embodiment is thus capable of accurately detecting the Dir initial characteristic with respect to a wide range of temperature environment, thereby acquiring the state of health SOH of the cell more accurately than the existing method.

The temperature sensor 70 (see Figs. 13 and 14) is provided as a temperature measuring means for measuring the surface temperature of each cell of the secondary battery 100.

As for the state of charge SOC, if the battery electro motive force Vemf can be accurately obtained by the measurement principle described above or the like, the obtained electro motive force can be defined as a voltage at which the state of charge of the secondary battery 10 is 100%.

Examples of the control circuit having a diagnostic function provided in the BMS of the present invention include the following.

(1) Discharging-Based Diagnostic Circuit

Fig. 13 is a circuit diagram showing a circuit 300 capable of diagnosis based on discharging.

As shown in Fig. 13, the circuit 300 mainly includes a plurality of cells B1, B2, .., BN, which are power storage elements connected in series, switching elements SW1, SW2, .., SWN connected to the (+) and (-) terminals of each of the cells B1, B2, .., BN, the current sensor 60, the temperature sensor 70 capable of measuring the temperature of each of the cells B1, B2, .., BN, a load 200, and a charger 210 connected to the (+) and (-) terminals at both ends of the secondary battery 100. The circuit 300 includes a voltmeter for measuring a terminal voltage for each of the cells B1, B2, .., BN.

The operation of the circuit 300 is controlled by the microcomputer 3a as described above.

With this circuit configuration, as described above, it is possible to perform diagnosis of the cells by accurately calculating the SOH for each of the cells B1, B2, .., BN with respect to a wide range of temperature environment while performing discharging.

(2) Charging-Based Diagnostic Circuit

Fig. 14 is a circuit diagram showing a circuit 400 capable of diagnosis based on charging.
As shown in Fig. 14, the circuit 400 mainly includes a plurality of cells B1, B2, .., BN, which are power storage elements connected in series, switching elements SW1, SW2, .., SWN connected to the (+) and (-) terminals of each cell, the current sensor 60, the temperature sensor 70 capable of measuring the temperature of each of the cells B1, B2, .., BN, a load 200, and a charger 210 connected to the (+) and (-) terminals at both ends of the secondary battery 100. The circuit 400 includes a charger for charging each of the cells B1, B2, .., BN, and a voltmeter for measuring a terminal voltage of each of the cells B1, B2, .., BN.
The operation of the circuit 400 is controlled by the microcomputer 3a as described above.
With this circuit configuration, as described above, it is possible to perform diagnosis of the cells by accurately calculating the SOH for each of the cells B1, B2, .., BN with respect to a wide range of temperature environment while performing charging.
The BMU 3 of the present embodiment is characterized by having a diagnostic function. The diagnosis of the power storage element included in the power storage element unit may also be performed, for example, by externally attaching the BMU 3 of the present embodiment to a power storage element unit in which a BMS has already been incorporated. More specifically, it is possible to attach the BMU 3 of the present embodiment to an apparatus in which another power storage element is incorporated, so as to measure the state of health SOH of another power storage element. This makes it possible to diagnose not only a power storage element connected to the BMU 3 in advance but also a power storage element connected to another apparatus, thereby improving the versatility of the BMU 3.

[Method 1]

As described above, in the BMU 3 of the present embodiment, the microcomputer 3a, which is an example of the control unit, is capable of calculating the overvoltage $\delta$ during the operation of the secondary battery 100 and the Dir according to the battery equation of [Math. 25] and the equation of [Math. 28] based on the measured values of the rising voltage and the current at the start of charging of the secondary battery 100. Further, the state of health SOH can be detected by comparing the obtained Dir with Dir of a secondary battery in a brand-new state. This enables accurate and instantaneous detection of SOH of the secondary battery 100. Therefore, the battery state (for example, the charging state) of the secondary battery 100 can be recognized whenever necessary.

[Method 2]

Further, in the BMU 3 of the present embodiment, the microcomputer 3a determines an accurate change in electro motive force at the stationary state based on the measured value of the fall voltage at the time when the charging of the secondary battery 100 is blocked, $\Delta\eta$eq and $\eta$eq* obtained from [Math. 9] to [Math. 11], and the "battery equation", and determines the state of charge SOC by comparing the result with a comparison table having a previously-measured electro motive force. As a result, even if the capacity of the secondary battery 100 decreases after long-term use, the state of charge at that time can be acquired as a ratio and as an absolute value. This will alleviate use's anxiety about energy depletion.
In Method 1 described above, the BMU 3 calculates the overvoltage $\delta$ during the operation of the secondary battery 100 and the Dir based on the "measured values of the rising voltage and current at the start of charging" of the secondary battery 100 using the battery equation of [Math. 25] and the equation of [Math. 28]. The "measured values of rising voltage and current at the start of charging" refers to an example of the "predetermined conditions regarding charging or discharging" of a secondary battery acquired by the microcomputer 3a via various measurement means.
Examples of the "predetermined conditions regarding charging or discharging" include:

(1) Time course of the fall voltage at the start of discharging
(2) Time course of the rising voltage at the start of charging
(3) Measured value of the rising voltage when discharging is blocked
(4) Measured value of the fall voltage when charging is blocked
(5) Measured value of the rising voltage when the charging current is increased or when the discharging current is decreased
(6) Time course of the fall voltage when the charging current is decreased or when the discharging current is increased
(7) Time course of the fall voltage in the transition from charging to discharging
(8) Measured value of the rising voltage in the transition from discharging to charging

The BMU 3 is capable of determining the overvoltage $\delta$ during the operation of the secondary battery 100 and the Dir by calculation using the battery equation of [Math. 25] and the equation of [Math. 28] based on these conditions. Therefore, the same effects as those of the present invention are exerted.

REFERENCE NUMERALS

1     Detection Device
10    Secondary Battery (Power Storage Element)
12    Current Detector (Current Measuring Means)
13    Voltage Detector (Voltage Measuring Means)
14    Measurement Controller (Control Unit)

**Claims**

1. A SOH/SOC detecting device (1) for a power storage element (10) for detecting the state of health SOH and the state of charge SOC of a power storage element (10), the device comprising:

   a measuring means (13) for measuring a voltage and a current of the power storage element (10); and
   a control unit (14) having a calculating means for executing a predetermined calculation,

   **characterized in that**:

   the control unit (14) is configured to determine overvoltage $\delta$ during operation of the power storage element (10) by calculation based on measured values of rising voltage and current at a start of charging of the power storage element (10) according to a battery equation of [Math. 1].

   [Math. 1]

   $$\Delta v = v - \eta^*_{eq}$$

   $$\Delta v_1 = \delta + \frac{2}{f}\tanh\left(\frac{1}{2}f\delta\right)$$

   wherein $\Delta v$ represents a differential voltage between a terminal voltage v of the power storage element (10) and an electro motive force $\eta eq^*$, $\Delta v_1$ represents a potential difference generated by an oxidation-reduction reaction on an electrode surface during operation, and the constant f represents a physical constant based on the Faraday constant, the Boltzmann constant, and the absolute temperature.

2. The SOH/SOC detecting device (1) for a power storage element (10) according to claim 1, wherein the control unit (14) determines the overvoltage $\delta$ during operation according to the condition of [Math. 1] where the two equations are equal.

3. The SOH/SOC detecting device (1) for a power storage element (10) according to claim 1 or 2, wherein the control unit (14) measures a time course of a fall voltage when charging of the power storage element (10) is blocked to calculate electrolyte characteristics of the power storage element (10).

4. The SOH/SOC detecting device (1) for a power storage element (10) according to any one of claims 1 to 3, wherein the control unit (14) determines the dynamic internal resistance Dir during charging according to the measured value of the voltage and the battery equation of [Math. 1], and calculates the state of health SOH from the Dir.

5. The SOH/SOC detecting device (1) for a power storage element (10) according to any one of claims 1 to 4, wherein the control unit (14) obtains a battery capacity by determining a battery-specific coefficient according to [Math. 2], which is a voltage-current characteristic expression with respect to the overvoltage δ, according to the measured value of the voltage and the battery equation of [Math. 1].

[Math. 2]

$$I = 2K_0 S_c \ \sinh\left(\frac{1}{2}f\delta\right)$$

6. A SOH/SOC detecting device (1) for a power storage element (10), the device being operable to detect the state of health SOH and the state of charge SOC of a power storage element (10) and comprising:

a measuring means (13) for measuring a voltage and a current of the power storage element (10); and
a control unit (14) having a calculating means for executing a predetermined calculation,

**characterized in that**:

the control unit (14) is configured to determine overvoltage δ during operation of the power storage element (10) by calculation based on a predetermined condition regarding charging or discharging of the power storage element (10) according to the battery equation of [Math. 1].

[Math. 1]

$$\Delta v = v - \eta_{eq}^*$$

$$\Delta v_1 = \delta + \frac{2}{f}\tanh\left(\frac{1}{2}f\delta\right)$$

wherein $\Delta v$ represents a differential voltage between a terminal voltage v of the power storage element (10) and an electro motive force $\eta eq^*$, $\Delta v_1$ represents a potential difference generated by an oxidation-reduction reaction on an electrode surface during operation, and the constant f represents a physical constant based on the Faraday constant, the Boltzmann constant, and the absolute temperature.

7. The SOH/SOC detecting device (1) for a power storage element (10) according to claim 6,
wherein the predetermined condition is a time course of a fall voltage at a start of discharging.

8. The SOH/SOC detecting device (1) for a power storage element (10) according to claim 6,
wherein the predetermined condition is a measured value of a rising voltage when discharging is blocked.

9. The SOH/SOC detecting device (1) for a power storage element (10) according to claim 6,
wherein the predetermined condition is a measured value of a rising voltage when a charging current is increased or when a discharging current is decreased.

10. The SOH/SOC detecting device (1) for a power storage element (10) according to claim 6,
wherein the predetermined condition is a time course of a fall voltage when a charging current is decreased or when a discharging current is increased.

11. The SOH/SOC detecting device (1) for a power storage element (10) according to claim 6,
wherein the predetermined condition is a time course of a fall voltage in transition from charging to discharging.

12. The SOH/SOC detecting device (1) for a power storage element (10) according to claim 6,
wherein the predetermined condition is a measured value of a rising voltage in transition from discharging to charging.

13. A power storage element managing unit for measuring the state of health SOH of a power storage element connected to a load, the unit comprising the SOH/SOC detecting device (1) according to claim 1 or 6;
wherein the control unit (14) comprises:

a SOH calculation unit (49) that calculates the state of health SOH of the power storage element (10) based on dynamic internal resistance Dir of the power storage element (10) in a brand-new state and current dynamic internal resistance Dir of the power storage element (10);
a dynamic internal resistance measurement unit (50) that measures current dynamic internal resistance Dir of the power storage element (10) while performing charging or discharging of the power storage element (10); and
a storage unit (51) that stores the dynamic internal resistance Dir of the power storage element (10) in a brand-new state.

14. The power storage element managing unit according to claim 13, further comprising:

a temperature measuring means (70) for measuring a temperature of the power storage element (10), wherein the control unit (14) comprises an acquisition unit that acquires the temperature of the power storage element (10) by the temperature measuring means (70), and, based on a relationship between the temperature of the power storage element (10) and the dynamic internal resistance Dir of the power storage element (10) in a brand-new state stored in advance, acquires a dynamic internal resistance Dir of the power storage element (10) in a brand-new state corresponding to the temperature of the power storage element (10), and the SOH calculation unit (49) calculates the state of health SOH of the power storage element (10) based on the dynamic internal resistance Dir of the power storage element (10) in a brand-new state acquired by the acquisition unit.

15. The power storage element managing unit according to claim 13 or 14,
wherein the power storage element managing unit is attached to an apparatus in which another power storage element (10) is incorporated, and measures the state of health SOH of another power storage element (10).

**Patentansprüche**

1. SOH/SOC-Erfassungsvorrichtung (1) für ein Energiespeicherelement (10) zum Erfassen des Gesundheitszustands SOH und des Ladezustands SOC eines Energiespeicherelements (10), wobei die Vorrichtung Folgendes aufweist:

ein Messmittel (13) zum Messen einer Spannung und eines Stroms des Energiespeicherelements (10); und eine Steuereinheit (14) mit einem Berechnungsmittel zum Ausführen einer vorbestimmten Berechnung,

**dadurch gekennzeichnet, dass**:

die Steuereinheit (14) eingerichtet ist, eine Überspannung δ während des Betriebs des Energiespeicherelements (10) durch Berechnung basierend auf gemessenen Werten einer ansteigenden Spannung und eines ansteigenden Stroms zu Beginn des Ladens des Energiespeicherelements (10) mit einer Batteriegleichung gemäß [Math. 1] zu bestimmen:

[Math. 1]

$$\Delta v = v - \eta^*_{eq}$$

$$\Delta v_1 = \delta + \frac{2}{f}\tanh\left(\frac{1}{2}f\delta\right)$$

wobei $\Delta v$ eine Differenzspannung zwischen einer Anschlussspannung v des Energiespeicherelements (10) und einer elektromotorischen Kraft $\eta eq^*$ repräsentiert, $\Delta v_1$ eine Potentialdifferenz repräsentiert, die durch eine Oxidations-Reduktions-Reaktion auf einer Elektrodenoberfläche während des Betriebs erzeugt wird, und die Konstante f eine physikalische Konstante basierend auf der Faraday-Konstante, der Boltzmann-Konstante und der absoluten Temperatur repräsentiert.

2. SOH/SOC-Erfassungsvorrichtung (1) für ein Energiespeicherelement (10) nach Anspruch 1,
wobei die Steuereinheit (14) die Überspannung $\delta$ während eines Betriebs unter der Bedingung bestimmt, dass in [Math. 1] die beiden Gleichungen gleich sind.

3. SOH/SOC-Erfassungsvorrichtung (1) für ein Energiespeicherelement (10) nach Anspruch 1 oder 2,
wobei die Steuereinheit (14) einen zeitlichen Verlauf einer abfallenden Spannung misst, wenn das Laden des Energiespeicherelements (10) blockiert ist, um Elektrolyteigenschaften des Energiespeicherelements (10) zu berechnen.

4. SOH/SOC-Erfassungsvorrichtung (1) für ein Energiespeicherelement (10) nach einem der Ansprüche 1 bis 3,
wobei die Steuereinheit (14) den dynamischen Innenwiderstand Dir während des Ladens gemäß dem gemessenen Wert der Spannung und der Batteriegleichung gemäß [Math. 1] bestimmt und den Gesundheitszustand SOH aus dem Dir berechnet.

5. SOH/SOC-Erfassungsvorrichtung (1) für ein Energiespeicherelement (10) nach einem der Ansprüche 1 bis 4,
wobei die Steuereinheit (14) eine Batteriekapazität durch Bestimmen eines batteriespezifischen Koeffizienten gemäß [Math. 2], der ein Spannungs-Strom-Eigenschaftsausdruck in Bezug auf die Überspannung $\delta$ ist, gemäß dem gemessenen Wert der Spannung und der Batteriegleichung gemäß [Math. 1] erhält.

[Math. 2]

$$I = 2K_0 S_c \ \sinh\left(\frac{1}{2}f\delta\right)$$

6. SOH/SOC-Erfassungsvorrichtung (1) für ein Energiespeicherelement (10), wobei die Vorrichtung eingerichtet ist, den Gesundheitszustand SOH und den Ladezustand SOC eines Energiespeicherelements (10) zu erfassen, und Folgendes aufweist:

ein Messmittel (13) zum Messen einer Spannung und eines Stroms des Energiespeicherelements (10); und
eine Steuereinheit (14) mit einem Berechnungsmittel zum Ausführen einer vorbestimmten Berechnung,

**dadurch gekennzeichnet, dass**:

die Steuereinheit (14) eingerichtet ist, eine Überspannung $\delta$ während des Betriebs des Energiespeicherelements (10) durch Berechnung basierend auf einer vorbestimmten Bedingung bezüglich des Ladens oder Entladens des Energiespeicherelements (10) gemäß der Batteriegleichung gemäß [Math. 1] zu bestimmen:

[Math. 1]

$$\Delta v = v - \eta_{eq}^*$$

$$\Delta v_1 = \delta + \frac{2}{f}\tanh\left(\frac{1}{2}f\delta\right)$$

wobei $\Delta v$ eine Differenzspannung zwischen einer Anschlussspannung v des Energiespeicherelements (10) und einer elektromotorischen Kraft $\eta eq^*$ repräsentiert, $\Delta v_1$ eine Potentialdifferenz repräsentiert, die durch eine Oxidations-Reduktions-Reaktion auf einer Elektrodenoberfläche während des Betriebs erzeugt wird, und die Konstante f eine physikalische Konstante basierend auf der Faraday-Konstante, der Boltzmann-Konstante und der absoluten Temperatur repräsentiert.

7. SOH/SOC-Erfassungsvorrichtung (1) für ein Energiespeicherelement (10) nach Anspruch 6,
wobei die vorbestimmte Bedingung ein zeitlicher Verlauf einer abfallenden Spannung zu Beginn des Entladens ist.

**8.** SOH/SOC-Erfassungsvorrichtung (1) für ein Energiespeicherelement (10) nach Anspruch 6,
wobei die vorbestimmte Bedingung ein Messwert einer ansteigenden Spannung ist, wenn das Entladen blockiert ist.

**9.** SOH/SOC-Erfassungsvorrichtung (1) für ein Energiespeicherelement (10) nach Anspruch 6,
wobei die vorbestimmte Bedingung ein Messwert einer ansteigenden Spannung ist, wenn ein Ladestrom erhöht wird oder wenn ein Entladestrom verringert wird.

**10.** SOH/SOC-Erfassungsvorrichtung (1) für ein Energiespeicherelement (10) nach Anspruch 6,
wobei die vorbestimmte Bedingung ein zeitlicher Verlauf einer abfallenden Spannung ist, wenn ein Ladestrom verringert wird oder wenn ein Entladestrom erhöht wird.

**11.** SOH/SOC-Erfassungsvorrichtung (1) für ein Energiespeicherelement (10) nach Anspruch 6,
wobei die vorbestimmte Bedingung ein zeitlicher Verlauf einer abfallenden Spannung beim Übergang vom Laden zum Entladen ist.

**12.** SOH/SOC-Erfassungsvorrichtung (1) für ein Energiespeicherelement (10) nach Anspruch 6,
wobei die vorbestimmte Bedingung ein Messwert einer ansteigenden Spannung beim Übergang vom Entladen zum Laden ist.

**13.** Energiespeicherelement-Verwaltungseinheit zum Messen des Gesundheitszustands SOH eines mit einer Last verbundenen Energiespeicherelements, wobei die Einheit die SOH/SOC-Erfassungsvorrichtung (1) nach Anspruch 1 oder 6 aufweist;
wobei die Steuereinheit (14) Folgendes aufweist:

eine SOH-Berechnungseinheit (49), die den Gesundheitszustand SOH des Energiespeicherelements (10) basierend auf dem dynamischen Innenwiderstand Dir des Energiespeicherelements (10) in einem brandneuen Zustand und dem aktuellen dynamischen Innenwiderstand Dir des Energiespeicherelements (10) berechnet;
eine Messeinheit (50) für den dynamischen Innenwiderstand, die den aktuellen dynamischen Innenwiderstand Dir des Energiespeicherelements (10) misst, während das Energiespeicherelements (10) geladen oder entladen wird; und
eine Speichereinheit (51), die den dynamischen Innenwiderstand Dir des Energiespeicherelements (10) in einem brandneuen Zustand speichert.

**14.** Energiespeicherelement-Verwaltungseinheit nach Anspruch 13, die ferner Folgendes aufweist:

ein Temperaturmessmittel (70) zum Messen einer Temperatur des Energiespeicherelements (10),
wobei die Steuereinheit (14) eine Erfassungseinheit aufweist, die die Temperatur des Energiespeicherelements (10) durch das Temperaturmessmittel (70) erfasst und basierend auf einer Beziehung zwischen der Temperatur des Energiespeicherelements (10) und dem dynamischen Innenwiderstand Dir des Energiespeicherelements (10) in einem brandneuen Zustand, der im Voraus gespeichert wird, einen dynamischen Innenwiderstand Dir des Energiespeicherelements (10) in einem brandneuen Zustand erfasst, der der Temperatur des Energiespeicherelements (10) entspricht, und die SOH-Berechnungseinheit (49) den Gesundheitszustand SOH des Energiespeicherelements (10) basierend auf dem dynamischen Innenwiderstand Dir des Energiespeicherelements (10) in einem brandneuen Zustand berechnet, der durch die Erfassungseinheit erfasst wird.

**15.** Energiespeicherelement-Verwaltungseinheit nach Anspruch 13 oder 14,
wobei die Energiespeicherelement-Verwaltungseinheit an einer Vorrichtung angebracht ist, in der ein anderes Energiespeicherelement (10) eingebaut ist, und den Gesundheitszustand SOH eines anderen Energiespeicherelements (10) misst.

## Revendications

**1.** Dispositif de détection de SOH/SOC (1) pour un élément de stockage d'énergie (10) pour détecter l'état de santé SOH et l'état de charge SOC d'un élément de stockage d'énergie (10), le dispositif comprenant :

un moyen de mesure (13) pour mesurer une tension et un courant de l'élément de stockage d'énergie (10) ; et
une unité de commande (14) ayant un moyen de calcul pour exécuter un calcul prédéterminé,

**caractérisé en ce que** :

l'unité de commande (14) est configurée pour déterminer une surtension $\delta$ pendant le fonctionnement de l'élément de stockage d'énergie (10) par un calcul basé sur des valeurs mesurées de tension et de courant croissants à un début de charge de l'élément de stockage d'énergie (10) selon une équation de batterie de [Math. 1]:

[Math. 1]

$$\Delta v = v - \eta_{eq}^{*}$$

$$\Delta v_1 = \delta + \frac{2}{f}\tanh\left(\frac{1}{2}f\delta\right)$$

dans lequel $\Delta v$ représente une tension différentielle entre une tension de borne v de l'élément de stockage d'énergie (10) et une force électromotrice $\eta eq^{*}$, $\Delta v_1$ représente une différence de potentiel générée par une réaction d'oxydoréduction sur une surface d'électrode pendant le fonctionnement, et la constante f représente une constante physique basée sur la constante de Faraday, la constante de Boltzmann et la température absolue.

2. Dispositif de détection de SOH/SOC (1) pour un élément de stockage d'énergie (10) selon la revendication 1, dans lequel l'unité de commande (14) détermine la surtension $\delta$ pendant le fonctionnement selon la condition de [Math. 1] où les deux équations sont égales.

3. Dispositif de détection de SOH/SOC (1) pour un élément de stockage d'énergie (10) selon la revendication 1 ou 2, dans lequel l'unité de commande (14) mesure une évolution temporelle d'une tension de chute lorsque la charge de l'élément de stockage d'énergie (10) est bloquée pour calculer des caractéristiques d'électrolyte de l'élément de stockage d'énergie (10).

4. Dispositif de détection de SOH/SOC (1) pour un élément de stockage d'énergie (10) selon l'une quelconque des revendications 1 à 3, dans lequel l'unité de commande (14) détermine la résistance interne dynamique Dir pendant la charge selon la valeur mesurée de la tension et l'équation de batterie de [Math. 1], et calcule l'état de santé SOH à partir de la Dir.

5. Dispositif de détection de SOH/SOC (1) pour un élément de stockage d'énergie (10) selon l'une quelconque des revendications 1 à 4, dans lequel l'unité de commande (14) obtient une capacité de batterie en déterminant un coefficient spécifique à la batterie selon [Math. 2], qui est une expression de caractéristique de tension-courant par rapport à la surtension $\delta$, selon la valeur mesurée de la tension et l'équation de batterie de [Math. 1].

[Math. 2]

$$I = 2K_0 S_c \ \sinh\left(\frac{1}{2}f\delta\right)$$

6. Dispositif de détection de SOH/SOC (1) pour un élément de stockage d'énergie (10), le dispositif pouvant fonctionner pour détecter l'état de santé SOH et l'état de charge SOC d'un élément de stockage d'énergie (10) et comprenant :

un moyen de mesure (13) pour mesurer une tension et un courant de l'élément de stockage d'énergie (10) ; et une unité de commande (14) ayant un moyen de calcul pour exécuter un calcul prédéterminé,

**caractérisé en ce que** :

l'unité de commande (14) est configurée pour déterminer une surtension $\delta$ pendant le fonctionnement de l'élément de stockage d'énergie (10) par un calcul basé sur une condition prédéterminée concernant la charge ou la décharge de l'élément de stockage d'énergie (10) selon l'équation de batterie de [Math. 1]:

[Math. 1]

$$\Delta v = v - \eta_{eq}^*$$

$$\Delta v_1 = \delta + \frac{2}{f} \tanh\left(\frac{1}{2} f \delta\right)$$

dans lequel $\Delta v$ représente une tension différentielle entre une tension de borne v de l'élément de stockage d'énergie (10) et une force électromotrice $\eta$eq*, $\Delta v_1$ représente une différence de potentiel générée par une réaction d'oxydoréduction sur une surface d'électrode pendant le fonctionnement, et la constante f représente une constante physique basée sur la constante de Faraday, la constante de Boltzmann et la température absolue.

7. Dispositif de détection de SOH/SOC (1) pour un élément de stockage d'énergie (10) selon la revendication 6, dans lequel la condition prédéterminée est une évolution temporelle d'une tension de chute à un début de décharge.

8. Dispositif de détection de SOH/SOC (1) pour un élément de stockage d'énergie (10) selon la revendication 6, dans lequel la condition prédéterminée est une valeur mesurée d'une tension croissante lorsque la décharge est bloquée.

9. Dispositif de détection de SOH/SOC (1) pour un élément de stockage d'énergie (10) selon la revendication 6, dans lequel la condition prédéterminée est une valeur mesurée d'une tension croissante lorsqu'un courant de charge est augmenté ou lorsqu'un courant de décharge est diminué.

10. Dispositif de détection de SOH/SOC (1) pour un élément de stockage d'énergie (10) selon la revendication 6, dans lequel la condition prédéterminée est une évolution temporelle d'une tension de chute lorsqu'un courant de charge est diminué ou lorsqu'un courant de décharge est augmenté.

11. Dispositif de détection de SOH/SOC (1) pour un élément de stockage d'énergie (10) selon la revendication 6, dans lequel la condition prédéterminée est une évolution temporelle d'une tension de chute dans la transition de la charge à la décharge.

12. Dispositif de détection de SOH/SOC (1) pour un élément de stockage d'énergie (10) selon la revendication 6, dans lequel la condition prédéterminée est une valeur mesurée d'une tension croissante dans la transition de la décharge à la charge.

13. Unité de gestion d'élément de stockage d'énergie pour mesurer l'état de santé SOH d'un élément de stockage d'énergie connecté à une charge, l'unité comprenant le dispositif de détection de SOH/SOC (1) selon la revendication 1 ou 6 ;
dans laquelle l'unité de commande (14) comprend :

une unité de calcul de SOH (49) qui calcule l'état de santé SOH de l'élément de stockage d'énergie (10) sur la base de la résistance interne dynamique Dir de l'élément de stockage d'énergie (10) dans un état tout à fait nouveau et de la résistance interne dynamique actuelle Dir de l'élément de stockage d'énergie (10) ;
une unité de mesure de résistance interne dynamique (50) qui mesure la résistance interne dynamique actuelle Dir de l'élément de stockage d'énergie (10) tout en effectuant la charge ou la décharge de l'élément de stockage d'énergie (10) ; et
une unité de stockage (51) qui stocke la résistance interne dynamique Dir de l'élément de stockage d'énergie (10) dans un état tout à fait nouveau.

14. Unité de gestion d'élément de stockage d'énergie selon la revendication 13, comprenant en outre :

un moyen de mesure de température (70) pour mesurer une température de l'élément de stockage d'énergie (10), dans laquelle l'unité de commande (14) comprend une unité d'acquisition qui acquiert la température de l'élément de stockage d'énergie (10) par le moyen de mesure de température (70), et, sur la base d'une relation entre la température de l'élément de stockage d'énergie (10) et la résistance interne dynamique Dir de l'élément de stockage d'énergie (10) dans un état tout à fait nouveau stocké à l'avance, acquiert une résistance interne dynamique Dir de l'élément de stockage d'énergie (10) dans un état tout à fait nouveau correspondant à la température de l'élément de stockage d'énergie (10), et l'unité de calcul de SOH (49) calcule l'état de santé SOH de l'élément de stockage d'énergie (10) sur la base de la résistance interne dynamique Dir de l'élément de stockage d'énergie (10) dans un état tout à fait nouveau acquise par l'unité d'acquisition.

15. Unité de gestion d'élément de stockage d'énergie selon la revendication 13 ou 14,
dans laquelle l'unité de gestion d'élément de stockage d'énergie est fixée à un appareil dans lequel un autre élément de stockage d'énergie (10) est incorporé, et mesure l'état de santé SOH d'un autre élément de stockage d'énergie (10).

# FIG. 1

EP 3 913 726 B1

FIG. 2

## FIG. 3

FIG. 4

**FIG. 5**

$$I = 2K_0 S_c \ \sinh(\tfrac{1}{2}f\delta)$$

$Dir$

$I$

$I$

$\eta_{eq}^*$   $\delta$   $Dir \times I$   $v$

$\Delta v$

## FIG. 6

$$\Delta v_1 = \delta + \frac{2}{f}\tanh(f\delta)$$

$$\Delta v_2 = \frac{2}{f}\tanh(f\delta)$$

SOC; 10, 90%

SOC; 30, 70%

SOC; 50%

## FIG. 7

$$\Delta\eta_{eq}(\tau) = \Delta\eta_1(\tau) + \Delta\eta_2(\tau) = \Delta\eta_1(0)e^{-\frac{\tau}{T_1}} + \Delta\eta_2(0)e^{-\frac{\tau}{T_2}}$$

Battery terminal voltage V

Current I

$\Delta v(t_n)$

$\Delta\eta_{eq}(\tau)$

$\Delta\eta_2(\tau)$

$\Delta\eta_1(\tau)$

$\eta^*_{eq,n}$

$\eta^*_{eq,n+1}$

$\eta^*_{eq,n+2}$

$\Delta t_0$

$\Delta t$

$\Delta t_0$

time($\tau$)

$t_n$

$t_{n+1}$

EP 3 913 726 B1

FIG. 8

# FIG. 9

# FIG. 10

Charging/discharging voltage characteristics

EP 3 913 726 B1

# FIG. 11

FIG. 12

**FIG. 13**

# FIG. 14

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 3752249 B
- US 7075269 B
- CN 100395939
- US 2016344068 A1
- US 2008103709 A1
- US 2015357852 A1
- JP 2017066404 A

**Non-patent literature cited in the description**

- **YOSHIHARU MATSUDA et al.** Denki Kagaku Gai-ron'' (Electrochemistry). Maruzen Publishing Co.,Ltd
- **SHIRO HARUYAMA.** Hyomengijyutusha no tameno Denki Kagaku'' (Electrochemistry for Surface Engineer). Maruzen Publishing Co.,Ltd,